# EUROPEAN PATENT APPLICATION

(11) **EP 4 521 898 A1**
(43) Date of publication of application: **12.03.2025**
(21) Application number: 24198298.2
(22) Date of filing: 03.09.2024
(51) Int. Cl.: H10K 59/122, H10K 59/80, H10K 59/32

(54) **DISPLAY PANEL AND MANUFACTURING METHOD OF THE SAME**

(30) Priority: 05.09.2023 KR 20230117412
(71) Applicant: Samsung Display Co., Ltd., Gyeonggi-do 17113 (KR)
(72) Inventor: JO, Jungyun, 17113 Yongin-si (KR)
(74) Representative: Taor, Simon Edward William

(57) **Abstract**

Provided is a display panel including a base substrate, a circuit element layer disposed on the base substrate, a pixel defining layer disposed on the circuit element layer and including a light-emitting opening, a light-emitting element disposed on the circuit element layer and including a first electrode, a second electrode facing the first electrode, and a functional layer disposed between the first electrode and the second electrode, a metal pattern layer disposed on the pixel defining layer, and a low thermal conductive layer disposed between the pixel defining layer and the metal pattern layer, thereby having excellent display quality.

## Description

### CROSS-REFERENCE TO RELATED APPLICATION(S)

This application claims priority to and benefits of Korean Patent Application No. 10-2023-0117412 under 35 U.S.C. § 119, filed on September 05, 2023.

### BACKGROUND

### 1. Technical Field

Embodiments relate to a display panel and a method of manufacturing the display panel, and more particularly, to a display panel including a light-emitting element having a common layer and a method of manufacturing the display panel.

### 2. Description of the Related Art

Various display devices, which are used for multimedia electronic devices such as a television, a mobile phone, a tablet computer, a navigation system, a game console, and a wearable device, are being developed. Such display devices may include a display panel that displays an image. The display panel uses a so-called self-luminous display element to display image by emitting light from a light-emitting material including an organic compound, a quantum dot, or the like in a light-emitting layer disposed between electrodes facing each other.

For example, recently, with the increasing demand for the high-definition and portability of multi-media electronic devices, there is a need for display panels capable of reducing size and providing excellent high-resolution display quality.

### SUMMARY

Embodiments provide a display panel having excellent display quality.

Embodiments also provide a high-resolution display panel having excellent display quality.

Embodiments also provide a method of manufacturing a display panel, which is capable of improving display quality by not only minimizing damage to a light-emitting layer and a common layer in a light-emitting region, but also effectively disconnecting an organic film provided as a common layer in neighboring light-emitting regions.

However, embodiments are not limited to those set forth herein. The above and other embodiments will become more apparent to one of ordinary skill in the art to which the disclosure pertains by referencing the detailed description of the disclosure given below.

An embodiment provides a display panel including: a base substrate; a circuit element layer disposed on the base substrate; a pixel defining layer disposed on the circuit element layer and including a light-emitting opening; a light-emitting element disposed on the circuit element layer and including a first electrode, a second electrode facing the first electrode, and a functional layer disposed between the first electrode and the second electrode; a metal pattern layer disposed on the pixel defining layer; and a low thermal conductive layer disposed between the pixel defining layer and the metal pattern layer.

In an embodiment, the low thermal conductive layer may have a thermal conductivity in a range of about 1.0 W/mK or less.

In an embodiment, the functional layer may not overlap the metal pattern layer.

In an embodiment, the functional layer may include a light-emitting layer and an organic layer disposed on at least one of an upper portion or a lower portion of the light-emitting layer, wherein the organic layer may overlap the light-emitting opening and a portion of the pixel defining layer adjacent to the light-emitting opening and be spaced apart from the metal pattern layer.

In an embodiment, the low thermal conductive layer may include a polymer-type amorphous carbon film.

In an embodiment, the proportion of sp³ carbon bonds in the polymer-type amorphous carbon film may be in a range of about 50% to about 70%.

In an embodiment, the low thermal conductive layer may have a refractive index in a range of about 1.75 or less at about 550 nm wavelength and a density in a range of about 1.2 g/ cm³ to about 1.6 g/cm³.

In an embodiment, on a cross section perpendicular to the base substrate, a first width of the metal pattern layer in a direction may be smaller than a second width of the pixel defining layer in the direction.

In an embodiment, the first width may be about 1/2 or less of the second width.

In an embodiment, a width of the metal pattern layer in a direction may be smaller than a width of the low thermal conductive layer in the direction.

In an embodiment, the low thermal conductive layer may cover an upper surface and a side surface of the pixel defining layer.

In an embodiment, the low thermal conductive layer may be disposed on an upper surface of the pixel defining layer, and a side surface of the pixel defining layer may be covered by the functional layer.

In an embodiment, a concave portion may be formed on an upper surface of the pixel defining layer, and the low thermal conductive layer may be disposed in the concave portion.

In an embodiment, a first concave portion may be formed on an upper surface of the pixel defining layer, the low thermal conductive layer may be disposed in the first concave portion, a second concave portion may be formed on an upper surface of the low thermal conductive layer, and the metal pattern layer may be disposed in the second concave portion.

In an embodiment, a display panel divided into a plurality of light-emitting regions spaced apart from each other in plan view and a peripheral region disposed between the plurality of light-emitting regions may include: a base substrate; a circuit element layer disposed on the base substrate; a pixel defining layer disposed on the circuit element layer and including a light-emitting opening overlapping each of the plurality of light-emitting regions; a plurality of light-emitting elements including a first electrode disposed on the circuit element layer, a second electrode facing the first electrode, and a functional layer disposed between the first electrode and the second electrode; a metal pattern layer corresponding to the peripheral region and disposed on the pixel defining layer; and a low thermal conductive layer directly disposed between the pixel defining layer and the metal pattern layer.

In an embodiment, the first electrode of the plurality of light-emitting elements may overlap each of the plurality of light-emitting regions, the second electrode may be disposed as a common layer across the plurality of light-emitting elements, and the functional layer may not overlap the metal pattern layer and may be disposed in the plurality of light-emitting regions and a portion of the peripheral region adjacent to the plurality of light-emitting regions.

In an embodiment, the functional layer may include a light-emitting layer, a hole transport region disposed between the first electrode and the light-emitting layer, and an electron transport region disposed between the light-emitting layer and the second electrode, wherein the light-emitting layer may be disposed in the light-emitting opening, and at least one of the hole transport region or the electron transport region may be disposed in the light-emitting opening and extend above an upper surface of the pixel defining layer adjacent to the light-emitting opening.

In an embodiment, the plurality of light-emitting regions may include a first light-emitting region, a second light-emitting region, and a third light-emitting region, which emit light of different wavelength ranges, and the plurality of light-emitting elements may include a first light-emitting layer overlapping the first light-emitting region, a second light-emitting layer overlapping the second light-emitting region, and a third light-emitting layer overlapping the third light-emitting region, wherein the first light-emitting layer, the second light-emitting layer, and the third light-emitting layer may include different light-emitting materials, and the first, second, and third light-emitting elements may include the same hole transport region and the same electron transport region as each other.

In an embodiment, at least one edge portion of the hole transport region and the electron transport region disposed to extend above the upper surface of the pixel defining layer may be spaced apart from the metal pattern layer.

In an embodiment, in plan view, a metal layer boundary line defined by the edge portion and an edge portion of the metal pattern layer may be positioned in a peripheral region, and the edge portion may be closer to the plurality of light-emitting regions than the metal layer boundary line.

In an embodiment, the low thermal conductive layer may include a polymer-type amorphous carbon film.

In an embodiment, the proportion of sp³ carbon bonds in the polymer-type amorphous carbon film may be in a range of about 50% to about 70%, and the low thermal conductive layer may have a refractive index in a range of about 1.75 or less at about 550 nm wavelength and a density in a range of about 1.2 g/cm³ to about 1.6 g/cm³.

In an embodiment, on a cross section perpendicular to the base substrate, a first width of the metal pattern layer in a direction may be greater than each of a second width of an upper surface of the pixel defining layer adjacent to the metal pattern layer in the a direction and a third width of an upper surface of the low thermal conductive layer adjacent to the metal pattern layer in the direction.

In an embodiment, in plan view, a size of the metal pattern layer may be smaller than a size of the pixel defining layer.

In an embodiment, a method of manufacturing a display panel may include forming a first electrode on a circuit element layer; forming a pixel defining layer on the circuit element layer; forming a low thermal conductive layer on the pixel defining layer; forming a metal pattern layer on the low thermal conductive layer so as to overlap the pixel defining layer; providing a preliminary functional layer so as to overlap the pixel defining layer and the first electrode; forming a functional layer by providing a current to the metal pattern layer to remove a portion of the preliminary functional layer overlapping the metal pattern layer; forming a second electrode so as to cover the functional layer and the metal pattern layer; and forming an encapsulation layer on the second electrode.

In an embodiment, the metal pattern layer may be a Joule heating wire, and the forming of a functional layer by removing the portion of the preliminary functional layer may include removing the portion of the preliminary functional layer by sublimating the preliminary functional layer with heat generated in the metal pattern layer.

In an embodiment, the forming of the low thermal conductive layer may include forming a polymer-type amorphous carbon film with hydrocarbon gas using a deposition facility.

In an embodiment, the metal pattern layer may have a width smaller than that of the low thermal conductive layer in a direction.

In an embodiment, the functional layer may be formed so as not to overlap the metal pattern layer.

According to an aspect, there is provided a display device as set out in claim 1. Additional features are set out in claims 2 to 11. According to an aspect, there is provided a method of manufacturing a display device as set out in claim 12. Additional features are set out in claims 13 to 15.

### BRIEF DESCRIPTION OF THE DRAWINGS

The accompanying drawings are included to provide a further understanding of the inventive concept, and are incorporated in and constitute a part of the description. The drawings illustrate embodiments and, together with the description, serve to explain principles of the inventive concept. In the drawings:
FIG. 1A is a schematic perspective view of an electronic device according to an embodiment;
FIG. 1B is an exploded schematic perspective view of the electronic device according to an embodiment;
FIG. 2A is a schematic perspective view of an electronic device according to an embodiment;
FIG. 2B is an exploded schematic perspective view of the electronic device according to an embodiment;
FIG. 3 is a schematic cross-sectional view of a display panel according to an embodiment;
FIG. 4 is a schematic plan view of the display panel according to an embodiment;
FIG. 5 is a schematic plan view of a portion of the display panel according to an embodiment;
FIG. 6 is a schematic cross-sectional view of a portion of the display panel according to an embodiment;
FIG. 7 is a schematic cross-sectional view of a portion of the display panel according to an embodiment;
FIG. 8A is a schematic cross-sectional view of a light-emitting element according to an embodiment;
FIG. 8B is a schematic cross-sectional view of a light-emitting element according to an embodiment;
FIG. 9 is a schematic cross-sectional view illustrating a portion of the display panel according to an embodiment;
FIG. 10 is a schematic cross-sectional view illustrating a portion of the display panel according to an embodiment;
FIG. 11 is a schematic plan view of a portion of the display panel according to an embodiment;
FIG. 12 is a schematic cross-sectional view of a portion of the display panel according to an embodiment;
FIG. 13 is a schematic cross-sectional view of a portion of the display panel according to an embodiment;
FIG. 14 is a schematic cross-sectional view of a portion of the display panel according to an embodiment;
FIG. 15 is a schematic cross-sectional view of a portion of the display panel according to an embodiment; and
FIGS. 16A to 16H respectively illustrate steps of a method of manufacturing a display panel according to an embodiment.

### DETAILED DESCRIPTION OF THE EMBODIMENTS

In the following description, for the purposes of explanation, numerous specific details are set forth in order to provide a thorough understanding of various embodiments or implementations of the invention. As used herein, "embodiments" and "implementations" are interchangeable words that are non-limiting examples of devices or methods disclosed herein. It is apparent, however, that various embodiments may be practiced without these specific details or with one or more equivalent arrangements. Here, various embodiments do not have to be exclusive nor limit the disclosure. For example, specific shapes, configurations, and characteristics of an embodiment may be used or implemented in another embodiment.

Unless otherwise specified, the illustrated embodiments are to be understood as providing features of the invention. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the scope of the invention.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals denote like elements.

When an element or a layer is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. For the purposes of this disclosure, "at least one of A and B" may be understood to mean A only, B only, or any combination of A and B. Also, "at least one of X, Y, and Z" and "at least one selected from the group consisting of X, Y, and Z" may be construed as X only, Y only, Z only, or any combination of two or more of X, Y, and Z. As used herein, the term "and/or" includes any and all combinations of one or more of the associated listed items.

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one element's relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein should be interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various embodiments are described herein with reference to sectional and/or exploded illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, units, and/or modules being implemented by microprocessors or other similar hardware, they may be programmed and controlled using software (e.g., microcode) to perform various functions discussed herein and may optionally be driven by firmware and/or software. It is also contemplated that each block, unit, and/or module may be implemented by dedicated hardware, or as a combination of dedicated hardware to perform some functions and a processor (e.g., one or more programmed microprocessors and associated circuitry) to perform other functions. Also, each block, unit, and/or module of some embodiments may be physically separated into two or more interacting and discrete blocks, units, and/or modules without departing from the scope of the invention. Further, the blocks, units, and/or modules of some embodiments may be physically combined into more complex blocks, units, and/or modules without departing from the scope of the invention.

Hereinafter, embodiments will be described with reference to the drawings.

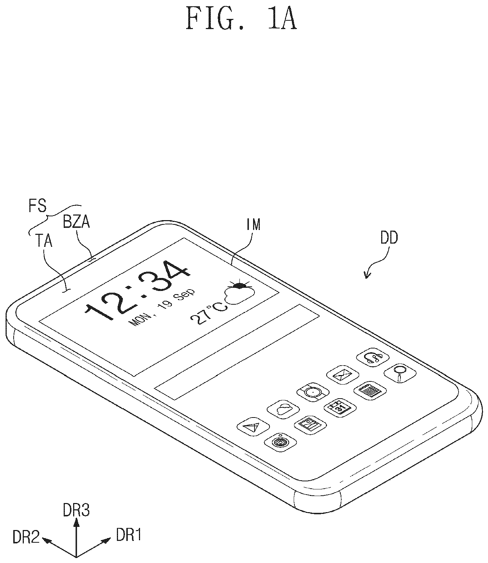

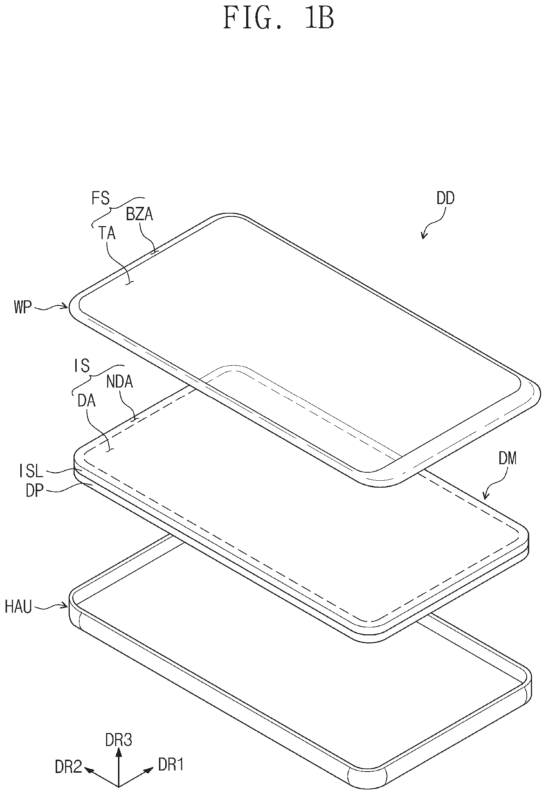

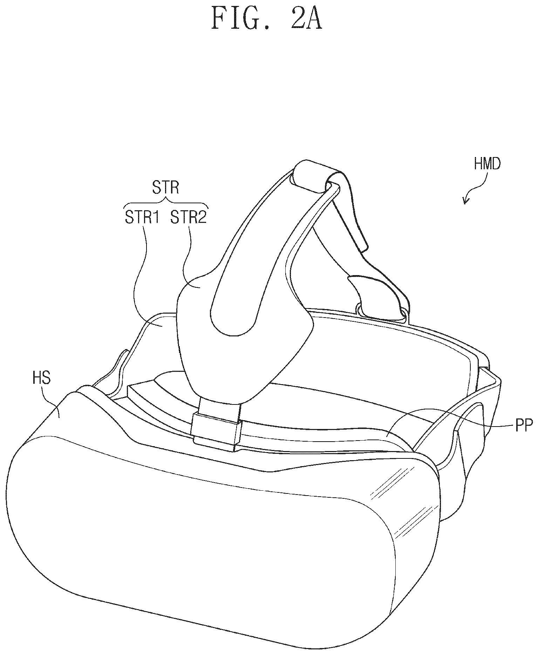

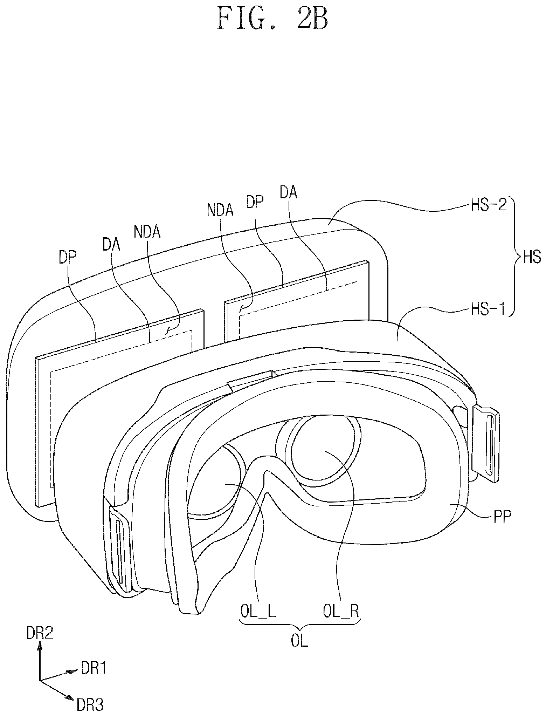

FIG. 1A is a schematic perspective view of an electronic device according to an embodiment. FIG. 1B is an exploded schematic perspective view of the electronic device according to an embodiment. FIG. 2A is a schematic perspective view of an electronic device according to an embodiment, and FIG. 2B is an exploded schematic perspective view of the electronic device according to an embodiment.

An electronic device DD according to an embodiment may be activated according to an electrical signal and display an image. For example, electronic devices DD may be small and medium-sized devices such as a monitor, a laptop computer, a personal digital terminal, a car navigation unit, a game console, a smartphone, a tablet, and a camera as well as large devices such as a television and an external billboard. However, these are presented only as examples and are not limited to any one embodiment as long as they do not depart from the concept of the invention.

In FIGS. 1A and 1B, an electronic device DD according to an embodiment is illustrated as a smart phone. For example, FIGS. 2A and 2B illustrate that an electronic device HMD according an embodiment is a wearable display device.

The electronic device DD according to an embodiment may be rigid or flexible. The term "Flexible" refers to the property of being bendable. For example, the flexible electronic device DD may include a curved device, a rollable device, or a foldable device.

FIG. 1A and the following drawings illustrate first to third directions DR1 to DR3, and directions indicated by the first to third directions DR1, DR2, and DR3 described herein are relative concepts and may be converted into other directions. In the description, the first direction DR1 and the second direction DR2 may be orthogonal to each other, and the third direction DR3 may be a normal direction with respect to a plane defined by the first direction DR1 and the second direction DR2.

The thickness direction of the electronic device DD may be parallel to the third direction DR3 which is the normal direction with respect to the plane defined by the first and second directions DR1 and DR2. In the description, the front (or upper) and rear (or lower) surfaces of members of the electronic device DD may be defined based on the third direction DR3. The front (or upper) and rear (or lower) surfaces of each member of the electronic device DD may be opposed to each other in the third direction DR3, and the normal direction of each of the front and rear surfaces may be substantially parallel to the third direction DR3. A separation distance between the front and rear surfaces defined along the third direction DR3 may correspond to the thickness of a member.

In the description, the expression "on a plane" or "in plan view" may be defined as viewed in the third direction DR3. In the description, the expression "on a cross section" may be defined as viewed in the first direction DR1 or the second direction DR2. Directions indicated by the first to third directions DR1, DR2, and DR3 are relative concepts and may be converted into other directions.

Referring to FIGS. 1A and 1B, the electronic device DD according to an embodiment may display an image IM through a display surface FS. The image IM may include a still image as well as a dynamic image. FIG. 1A illustrates a watch window and icons as an example of the image IM. The display surface FS on which the image IM is displayed may correspond to the front surface of the electronic device DD.

Referring to FIG. 1B, the electronic device DD according to an embodiment may include a window WP, a display module DM, and a housing HAU. The window WP and the housing HAU may be coupled to each other to form the exterior of the electronic device DD.

The window WP may include an optically transparent insulating material. For example, the window WP may include glass or plastic. The front surface of the window WP may define (or form) the display surface FS of the electronic device DD. The display surface FS may include a transmission region TA and a bezel region BZA. The transmission region TA may be an optically transparent region. For example, the transmission region TA may have a visible light transmittance in a range of about 90% or more.

The bezel region BZA may have a relatively low light transmittance, compared to the transmission region TA. The bezel region BZA may define (or form) the shape of the transmission region TA. The bezel region BZA may be adjacent to and surround the transmission region TA. In another example, the bezel region BZA may be omitted. The window WP may include at least one functional layer among an anti-fingerprint layer, a hard coating layer, and an anti-reflection layer, but embodiments are not limited thereto.

The display module DM may be disposed below the window WP. The display module DM may generate an image IM. The image IM generated by the display module DM may be displayed on the display surface IS of the display module DM and may be visually recognized by a user from the outside through the transmission region TA.

The display module DM may include a display region DA and a non-display region NDA. The display region DA may be activated according to an electrical signal. The non-display region NDA may be adjacent to the display region DA. The non-display region NDA may surround the display region DA. The non-display region NDA may be covered by the bezel region BZA and may not be visually recognized from the outside.

The housing HAU may be coupled to the window WP. The housing HAU may be coupled to the window WP to provide an internal space. The display module DM may be accommodated in the internal space.

The housing HAU may include a material having relatively high rigidity. For example, the housing HAU may include frames and/or plates made of glass, plastic, or metal, or a combination thereof. The housing HAU may reliably protect the components of the electronic device DD, which are accommodated in the internal space, from an external impact.

Referring to FIG. 1B, the display module DM according to an embodiment may include a display panel DP and an input sensor ISL. For example, the electronic device DD according to an embodiment may further include a protective member disposed on the lower surface of the display panel DP, or an anti-reflection member and/or an optical member disposed on the upper surface of the input sensor ISL.

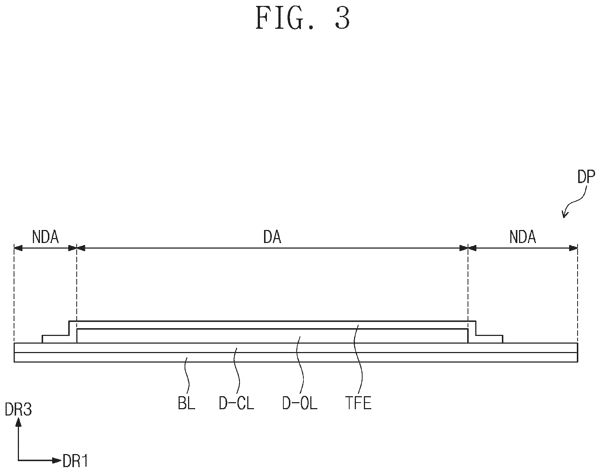

The input sensor ISL may obtain the coordinate information of an external input. The input sensor ISL may have a multi-layered structure. The input sensor ISL may include a single-layered conductive layer or a multi-layered conductive layer. The input sensor ISL may include a single-layered insulating layer or a multi-layered insulating layer. The input sensor ISL may sense an external input, for example, in a capacitive manner. In this invention, the operation manner of the input sensor ISL is not limited thereto, and in an embodiment, the input sensor ISL may sense an external input in an electromagnetic induction manner or a pressure-sensing manner. The input sensor ISL may be disposed (e.g., directly disposed) on an encapsulation layer TFE (see FIG. 3) of the display panel DP which will be described later. In the description, the expression "Component A is disposed directly on component B" means that no adhesive layer is disposed between component A and component B. In another embodiment, the input sensor ISL may be omitted.

FIG. 2A is a schematic perspective view of an electronic device HMD according to an embodiment. FIG. 2B is an exploded schematic perspective view of a portion of the electronic device HMD according to an embodiment.

The electronic device HMD according to an embodiment, which is illustrated in FIGS. 2A and 2B, may be activated according to an electrical signal and be a wearable device. The wearable device may be a device worn on a user's body and may include a head-mounted display (HMD) device that implements eXtended Reality (XR). FIGS. 2A and 2B illustrate that the electronic device HMD is a head-mounted display device, but embodiments are not limited thereto.

The electronic device HMD according to an embodiment, which is illustrated in FIGS. 2A and 2B, is a display device worn on a user's head. The electronic device HMD may provide an image in a state in which the actual peripheral vision of a user is blocked. A user wearing the electronic device HMD may be more readily immersed in virtual reality.

The electronic device HMD may include a body unit HS, a strap STR, a cushion portion PP, and a display panel DP. For example, the electronic device HMD may include various sensors and cameras.

The body unit HS may be worn on a user's head. The display panel DP which displays an image, an acceleration sensor, and the like may be accommodated in the body unit HS. The acceleration sensor may detect a user's movement and transmit a detected signal to the display panel DP. Accordingly, the display panel DP may provide an image corresponding to a change in the user's gaze. Therefore, the user may experience virtual reality similar to actual reality.

In the body unit HS, parts having various functions besides those described above may be accommodated. For example, a control unit for adjusting volume or screen brightness may be additionally disposed outside the body unit HS. The control unit may be provided in the form of a physical button, a touch sensor, or the like. For example, a proximity sensor that determines whether or not a user is wearing a device may be accommodated in the body unit HS. For example, an external display panel may be further disposed in the body unit HS.

The body unit HS may be separated into a body portion HS-1 and a cover portion HS-2. FIG. 2B illustrates a shape in which the body portion HS-1 and the cover portion HS-2 are separated from each other, but embodiments are not limited thereto. For example, the body portion HS-1 and the cover portion HS-2 may be provided as an integral unit and may not be separated from each other.

Display panels DP may be disposed between the body portion HS-1 and the cover portion HS-2. Each of the display panels DP may provide an image through a display region DA. Each of the display panels DP may include a non-display region NDA surrounding the display region DA. In an embodiment, the non-display region NDA may be disposed only on a side of the display region DA or may be omitted.

In FIG. 2B, an example is illustrated in which a left-eye image and a right-eye image are displayed through separate display panels DP, but embodiments are not limited thereto. In another example, the left-eye image and the right-eye image may be displayed through a single display panel. The display panels DP may be driven by separate driving units. Without being limited thereto, however, the display panels DP may be driven by a single driving unit. The display panels DP may generate images corresponding to input image data.

The strap STR may be coupled to the body unit HS so that the body unit HS may be readily worn by a user. The strap STR may include a main strap portion STR1 and an upper strap portion STR2.

The main strap portion STR1 may be worn along the head circumference of a user. The main strap portion STR1 may fix the body unit HS to the user so that the body unit HS may be in close contact with the user's head. The upper strap portion STR2 may connect the body unit HS and the main strap portion STR1 to each other along the upper portion of the user's head. The upper strap portion STR2 may prevent the body unit HS from falling down. For example, the upper strap portion STR2 may distribute the load of the body unit HS to further improve the wearing comfort of the user.

As long as the body unit HS is fixed to the user, the strap STR may be modified into various forms besides those illustrated in FIG. 2A. For example, in another embodiment, the upper strap portion STR2 may be omitted. In another embodiment, the strap STR may be modified into various forms, such as a helmet coupled to the body unit HS, or eyeglass temples coupled to the body unit HS.

The cushion portion PP may be disposed between the body unit HS and the user's head. The cushion portion PP may be made of a material having a freely deformable shape. For example, the cushion portion PP may be formed of a polymer resin (e.g., polyurethane, polycarbonate, polypropylene, and polyethylene) or a sponge made by foaming and molding a rubber solution, a urethane-based material, or an acrylic-based material. However, embodiments are not limited thereto.

The cushion portion PP may function the body unit HS to be in close contact with the user, thereby improving the wearing comfort of the user. The cushion portion PP may be detached from the body unit HS. In another embodiment, the cushion portion PP may be omitted.

An optical system OL may be disposed inside the body portion HS-1 of the body unit HS. The optical system OL may enlarge an image provided from the display panels DP. Each of the display panels DP may display the image in the third direction DR3 through the display region DA parallel to the first direction DR1 and the second direction DR2 intersecting the first direction DR1. The optical system OL may be spaced apart from the display panels DP in the third direction DR3. The optical system OL may be disposed between the display panels DP and the user's eyes. The optical system OL may include a right-eye optical system OL_R and a left-eye optical system OL_L. The left-eye optical system OL_L may enlarge and provide an image to the left pupil of the user, and the right-eye optical system OL_R may enlarge and provide an image to the right pupil of the user.

The left-eye optical system OL_L and the right-eye optical system OL_R may be spaced apart from each other in the first direction DR1. The distance between the right-eye optical system OL_R and the left-eye optical system OL_L may be adjusted in response to the distance between the two eyes of the user. For example, the distance between the optical system OL and the display panels DP may be adjusted according to the vision of the user.

The optical system OL may be a convex aspherical lens. For example, the optical system OL may be a pancake lens, but embodiments are not limited thereto. In this embodiment, each of the left-eye optical system OL_L and the right-eye optical system OL_R is described as being composed of only one lens, but embodiments are not limited thereto. For example, each of the left-eye optical system OL_L and the right-eye optical system OL_R may include lenses.

The display panels DP included in the electronic devices DD and HMD according to the embodiment described with reference to FIGS. 1A to 2B may be organic light-emitting display panels, inorganic light-emitting display panels, organic-inorganic light-emitting display panels, quantum dot display panels, micro LED display panels, or nano LED display panels. In this embodiment, the display panels DP are described as organic light-emitting display panels, but embodiments are not limited thereto.

FIG. 3 is a schematic cross-sectional view of a display panel DP according to an embodiment. The display panel DP according to an embodiment may include a base substrate BL, a circuit element layer D-CL disposed on the base substrate BL, a display element layer D-OL, and an encapsulation layer TFE. The display panel DP may include a display region DA and a non-display region NDA. The display element layer D-OL may be disposed to correspond to (or may overlap) the display region DA. However, embodiments are not limited thereto, and at least a portion of the display element layer D-OL may be disposed in the non-display region NDA.

The base substrate BL may be a support substrate on which the circuit element layer D-CL and the display element layer D-OL are provided. The base substrate BL may include a plastic substrate, a glass substrate, a metal substrate, an organic/inorganic composite material substrate, or the like. The base substrate BL may be a silicon substrate, a germanium substrate, or a silicon-on-insulator (SOI) substrate. For example, the base substrate BL may be a single-crystal silicon substrate, but embodiments are not limited thereto. In the description, the display region DA and the non-display region NDA may be regarded as being defined on the base substrate BL, and components disposed on the base substrate BL may also be regarded as being disposed to overlap the display region DA or the non-display region NDA.

The circuit element layer D-CL may include at least one insulating layer and a circuit element. The circuit element may include a signal line, a pixel driving circuit, and the like. The circuit element layer D-CL may be formed by a process of forming an insulating layer, a semiconductor layer, and a conductive layer by coating, deposition, etc., and then through a process of patterning the insulating layer, the semiconductor layer, and the conductive layer by a photolithography process.

The display element layer D-OL may include a light-emitting element. The light-emitting element may include a light-emitting layer or the like, which emits light.

The encapsulation layer TFE may include thin films. Some thin films may be disposed to improve optical efficiency, and other thin films may be disposed to protect the light-emitting element.

The encapsulation layer TFE may be a thin film encapsulation layer. The encapsulation layer TFE may be a single layer or a plurality of layers stacked with each other. The encapsulation layer TFE may include at least one insulating layer. The encapsulation layer TFE according to an embodiment may include at least one inorganic film (hereinafter referred to as an inorganic encapsulation film). For example, the encapsulation layer TFE according to an embodiment may include at least one organic film (hereinafter referred to as an organic encapsulation film) and at least one inorganic encapsulation film.

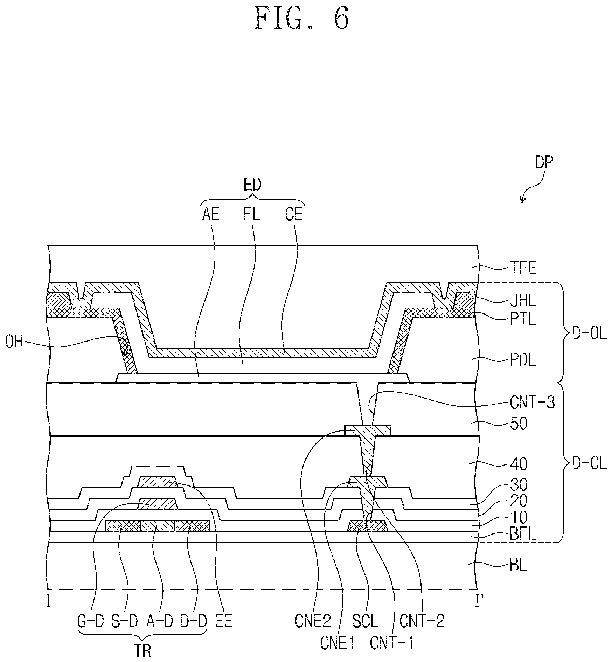

The inorganic encapsulation film may protect a light-emitting element ED (see FIG. 6) from moisture/oxygen, and the organic encapsulation film may protect the light-emitting element ED (see FIG. 6) from foreign substances such as dust particles. The inorganic encapsulation film may include silicon nitride, silicon oxynitride, silicon oxide, titanium oxide, or aluminum oxide, but embodiments are not limited thereto. The organic encapsulation film may include an acrylic-based compound, an epoxy-based compound, and the like. The organic encapsulation film may include a photopolymerizable organic material, but embodiments are not limited thereto.

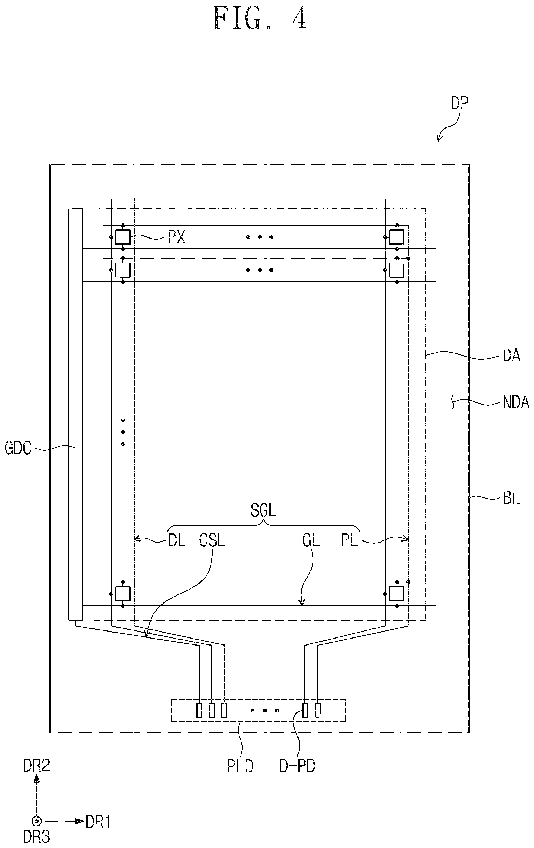

FIG. 4 is a schematic plan view of the display panel DP according to an embodiment. The display panel DP may include a base substrate BL divided into a display region DA and a non-display region NDA as described with reference to FIG. 3.

The display panel DP may include pixels PX disposed in the display region DA and signal lines SGL electrically connected to the pixels PX. The display panel DP may include a driving circuit GDC and a pad portion PLD which are disposed in the non-display region NDA.

The pixels PX may be arranged in the first and second directions DR1 and DR2. The pixels PX may include pixel rows extending in the first direction DR1 and arranged in the second direction DR2 and pixel columns extending in the second direction DR2 and arranged in the first direction DR1.

The signal lines SGL may include gate lines GL, data lines DL, a power line PL, and a control signal line CSL. Each of the gate lines GL may be connected to a corresponding pixel of the pixels PX, and each of the data lines DL may be connected to a corresponding pixel of the pixels PX. The power line PL may be electrically connected to the pixels PX. The control signal line CSL may be connected to the driving circuit GDC to provide control signals to the driving circuit GDC.

The driving circuit GDC may include a gate driving circuit. The gate driving circuit may generate gate signals and sequentially output the generated gate signals to the gate lines GL. The gate driving circuit may further output another control signal to the pixel driving circuit.

The pad portion PLD may be a portion to which a flexible circuit board is connected. The pad portion PLD may include pixel pads D-PD, and the pixel pads D-PD may be pads for connecting the flexible circuit board to the display panel DP. Each of the pixel pads D-PD may be connected to a corresponding signal line among the signal lines SGL. The pixel pads D-PD may be connected to corresponding pixels PX through the signal lines SGL. For example, any one of the pixel pads D-PD may be connected to the driving circuit GDC.

For example, the pad portion PLD may further include input pads. The input pads may be pads for connecting the flexible circuit board to the input sensor ISL (see FIG. 1B). Without being limited thereto, however, the input pads may be disposed in the input sensor ISL (see FIG. 1B) and be connected to the pixel pads D-PD and a separate circuit board. In another example, the input sensor ISL (see FIG. 1B) may be omitted and may not include the input pads.

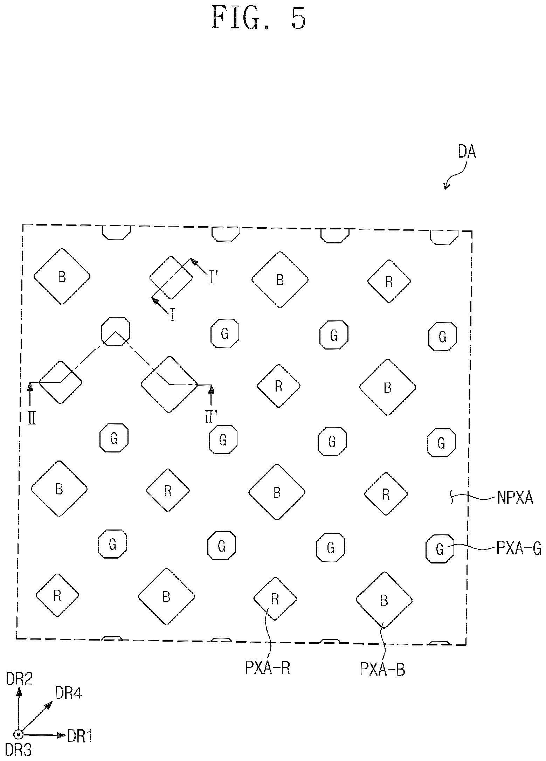

FIG. 5 is an enlarged schematic plan view of a portion of the display panel DP according to an embodiment. FIG. 5 illustrates a portion of the display region DA (see FIG. 1B) viewed from the display surface IS (see FIG. 1B) of the display module DM (see FIG. 1B). FIG. 5 illustrates an arrangement of light-emitting regions PXA-R, PXA-G, and PXA-B in the display panel DP (see FIG. 3) according to an embodiment.

The display panel DP according to an embodiment may include light-emitting regions PXA-R, PXA-G, and PXA-B spaced apart from each other in plan view and a peripheral region NPXA disposed between the light-emitting regions PXA-R, PXA-G, and PXA-B.

The display panel DP according to an embodiment may include three types of light-emitting regions PXA-R, PXA-G, and PXA-B which are distinguished from each other. In an embodiment, the three types of light-emitting regions PXA-R, PXA-G, and PXA-B illustrated in FIG. 5 may be repeatedly disposed throughout the display region DA. The light-emitting regions PXA-R, PXA-G, and PXA-B may also be referred to as pixel regions.

The display region DA may include a first light-emitting region PXA-R, a second light-emitting region PXA-G, and a third light-emitting region PXA-B which emit light of different wavelength ranges and are spaced apart from each other on a plane (or in plan view). For example, the display region DA may include a peripheral region NPXA. The peripheral region NPXA may be referred to as a non-light-emitting region. Referring to FIG. 5, the first light-emitting region PXA-R may correspond to a red pixel R, the second light-emitting region PXA-G may correspond to a green pixel G, and the third light-emitting region PXA-B may correspond to a blue pixel B.

The peripheral region NPXA may be disposed around the first to third light-emitting regions PXA-R, PXA-G, and PXA-B. The peripheral region NPXA may set (or define) boundaries of the first to third light-emitting regions PXA-R, PXA-G, and PXA-B. The peripheral region NPXA may surround the first to third light-emitting regions PXA-R, PXA-G, and PXA-B. In the peripheral region NPXA, a structure, such as a pixel defining layer PDL (see FIG. 6), which prevents color mixing among the first to third light-emitting regions (e.g., first to third pixel regions) PXA-R, PXA-G, and PXA-B, may be disposed so as to correspond to the peripheral region NPXA.

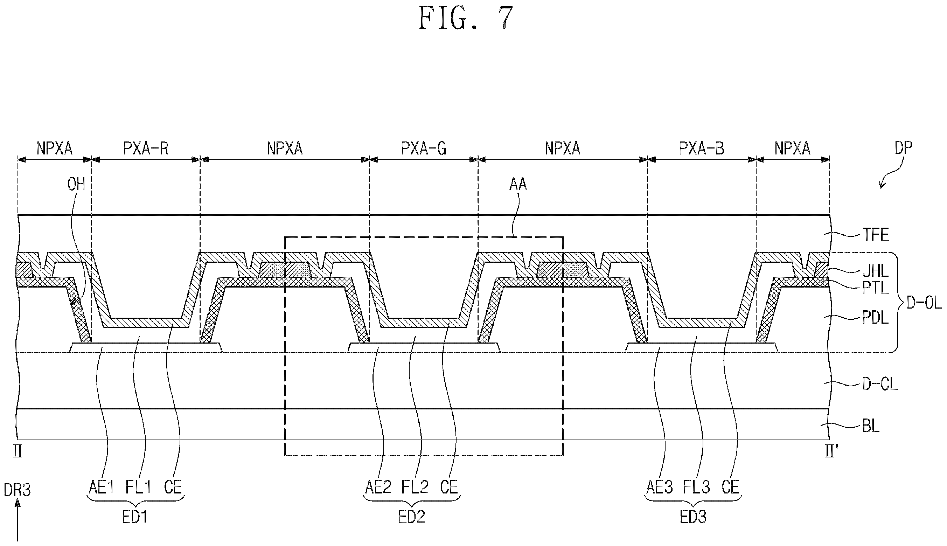

Since the display panel DP according to an embodiment includes a metal pattern layer JHL (see FIG. 7) overlapping the pixel defining layer PDL and a low thermal conductive layer PTL (see FIG. 7) disposed below the metal pattern layer JHL, which will be described later, and functional layers FL (see FIG. 6) may not be connected to each other at a portion corresponding to the peripheral region NPXA, it is possible to prevent leakage current from being transmitted to adjacent light-emitting regions PXA-R, PXA-G, and PXA-B. For example, the functional layers FL (see FIG. 6) disposed in the light-emitting regions PXA-R, PXA-G, and PXA-B may have excellent film properties to prevent damage. Thus, the display panel DP according to an embodiment may have excellent display quality.

The first to third light-emitting regions PXA-R, PXA-G, and PXA-B may respectively correspond to regions from which light provided from light-emitting elements ED 1, ED2, and ED3 (see FIG. 7) is emitted. The first to third light-emitting regions PXA-R, PXA-G, and PXA-B may be classified (or distinguished) according to the color of light emitted toward the outside of the display module DM (see FIG. 1B).

The first to third light-emitting regions PXA-R, PXA-G, and PXA-B may respectively provide first to third color lights having different colors. For example, the first color light may be red light, the second color light may be green light, and the third color light may be blue light. However, the examples of the first to third color lights are not limited thereto.

Each of the first to third light-emitting regions PXA-R, PXA-G, and PXA-B may be defined as a region in which the upper surface of a first electrode AE (see FIG. 6) of the light-emitting element is exposed by a light-emitting opening OH (see FIG. 6) which will be described later.

Each of the first to third light-emitting regions PXA-R, PXA-G, and PXA-B may be provided in plurality and may be repeatedly arranged in a certain arrangement in the display region DA. For example, the first and third light-emitting regions PXA-R and PXA-B may be alternately arranged along the first direction DR1 to form a 'first group'. The second light-emitting regions PXA-G may be arranged along the first direction DR1 to form a 'second group'. Each of the 'first group' and the 'second group' may be provided in plurality, and the 'first groups' and the 'second groups' may be arranged alternately with each other along the second direction DR2.

One second light-emitting region PXA-G may be spaced apart from one first light-emitting region PXA-R or one third light-emitting region PXA-B in a fourth direction DR4. The fourth direction DR4 may be defined as a direction between the first and second directions DR1 and DR2.

FIG. 5 illustrates an arrangement form of the first to third light-emitting regions PXA-R, PXA-G, and PXA-B, but embodiments are not limited thereto. For example, the first to third light-emitting regions PXA-R, PXA-G, and PXA-B may be arranged in various forms. In an embodiment, the first to third light-emitting regions PXA-R, PXA-G, and PXA-B may have a PENTILE^{™} arrangement form. In another example, the first to third light-emitting regions PXA-R, PXA-G, and PXA-B may have a stripe arrangement form or a Diamond Pixel^{™} arrangement form.

The first to third light-emitting regions PXA-R, PXA-G, and PXA-B may have various shapes on a plane (or in plan view). For example, the first to third light-emitting regions PXA-R, PXA-G, and PXA-B may have a polygonal, circular, or elliptical shape. FIG. 5 illustrates, on a plane (or in plan view), the first and third light-emitting regions PXA-R and PXA-B having a quadrangular shape (or diamond shape) and the second light-emitting region PXA-G having an octagonal shape.

The first to third light-emitting regions PXA-R, PXA-G, and PXA-B may have a same shape on a plane (or in plan view), or at least some of them may have shapes different from the others. FIG. 5 illustrates, on a plane (or in plan view), the first and third light-emitting regions PXA-R and PXA-B having a same shape and the second light-emitting region PXA-G having a shape different from those of the first and third light-emitting regions PXA-R and PXA-B.

At least some of the first to third light-emitting regions PXA-R, PXA-G, and PXA-B may have areas (or sizes) different from each other on a plane (or in plan view). In an embodiment, the area (or size) of the first light-emitting region PXA-R that emits red light may be larger than the area (or size) of the second light-emitting region PXA-G that emits green light and smaller than the area (or size) of the third light-emitting region PXA-B that emits blue light. However, the size relationship between the areas (or sizes) of the first to third light-emitting regions PXA-R, PXA-G, and PXA-B according to the color of emitted light is not limited thereto and may vary according to the design of the display panel DP according to an embodiment. For example, without being limited thereto, the first to third light-emitting regions PXA-R, PXA-G, and PXA-B may have a same area (or same size) on a plane (or in plan view).

For example, the shape, area (or size), and arrangement of the first to third light-emitting regions PXA-R, PXA-G, and PXA-B of the display panel DP according to an embodiment may be designed in various ways according to the color of emitted light or the size and configuration of the display panel DP included in the electronic device, and embodiments are not limited to the embodiment illustrated in FIG. 5. For example, in an embodiment, the display panel DP may further include a light-emitting region that emits white light in addition to the first to third light-emitting regions PXA-R, PXA-G, and PXA-B.

FIG. 6 is a schematic cross-sectional view of a partial region of the display panel DP according to an embodiment. FIG. 7 is a schematic cross-sectional view of a partial region of the display panel DP according to an embodiment and illustrates a portion corresponding to the light-emitting regions PXA-R, PXA-G, and PXA-B. FIG. 6 may be a schematic cross-sectional view of a portion corresponding to line I-I' of FIG. 5, and FIG. 7 may be a schematic cross-sectional view of a portion corresponding to line II-II' of FIG. 5.

FIG. 6 illustrates a cross section of a portion corresponding to the first light-emitting region PXA-R (see FIG. 5) and the periphery of the first light-emitting region PXA-R. However, the cross section illustrated in FIG. 6 is not limited to the first light-emitting region PXA-R and its peripheral region and may be a portion corresponding to any one light-emitting region included in the display panel DP.

Referring to FIG. 6, the display panel DP may include a base substrate BL, a circuit element layer D-CL, a display element layer D-OL, and an encapsulation layer TFE.

The circuit element layer D-CL may include a buffer layer BFL, a transistor TR, a signal transmission region SCL, first to fifth insulating layers 10, 20, 30, 40, and 50, an upper electrode pattern EE, and connection electrodes CNE1 and CNE2.

The buffer layer BFL may be disposed on the base substrate BL. The buffer layer BFL may improve bonding strength between the base substrate BL and a semiconductor pattern. The buffer layer BFL may include a silicon oxide layer and a silicon nitride layer. The silicon oxide layer and the silicon nitride layer may be alternately stacked with each other.

The semiconductor pattern may be disposed on the buffer layer BFL. The semiconductor pattern may include polysilicon. Without being limited thereto, however, the semiconductor pattern may include amorphous silicon or a metal oxide. FIG. 6 illustrates only a portion of the semiconductor pattern, and the semiconductor pattern may be further disposed in the light-emitting regions PXA-R, PXA-G, and PXA-B (see FIG. 5). The semiconductor pattern may be arranged in a specific rule across the light-emitting regions PXA-R, PXA-G, and PXA-B. The semiconductor pattern may have different electrical properties according to whether it is doped or not. The semiconductor pattern may include a first region having a high doping concentration and a second region having a low doping concentration. The first region may be doped with an N-type dopant or a P-type dopant. A P-type transistor may include the first region doped with a P-type dopant.

The first region may have higher conductivity than the second region and may substantially function as an electrode or signal line. The second region may substantially correspond to an active (or channel) of a transistor. For example, a portion of the semiconductor pattern may be an active of a transistor, another portion of the semiconductor pattern may be a source or drain of a transistor, and still another portion of the semiconductor pattern may be a conductive region.

A source S-D, an active A-D, and a drain D-D of a transistor TR may be formed from the semiconductor pattern. FIG. 6 illustrates a portion of the signal transmission region SCL formed from the semiconductor pattern. For example, the signal transmission region SCL may be connected to the drain D-D of the transistor TR on a plane (or in plan view).

The first to fifth insulating layers 10, 20, 30, 40, and 50 may be disposed above the buffer layer BFL. The first to fifth insulating layers 10, 20, 30, 40, and 50 may be inorganic layers or organic layers.

The first insulating layer 10 may be disposed on the buffer layer BFL. The first insulating layer 10 may cover the source S-D, active A-D, and drain D-D of the transistor TR and the signal transmission region SCL which are disposed on the buffer layer BFL. A gate G-D of the transistor TR may be disposed on the first insulating layer 10. The second insulating layer 20 may be disposed on the first insulating layer 10 to cover the gate G-D. The upper electrode pattern EE may be disposed on the second insulating layer 20. The third insulating layer 30 may be disposed on the second insulating layer 20 to cover the upper electrode pattern EE.

The first connection electrode CNE1 may be disposed on the third insulating layer 30. The first connection electrode CNE1 may be connected to the signal transmission region SCL through a contact hole CNT-1 passing through the first to third insulating layers 10, 20, and 30. The fourth insulating layer 40 may be disposed on the third insulating layer 30 to cover the first connection electrode CNE1. The fourth insulating layer 40 may be an organic layer.

The second connection electrode CNE2 may be disposed on the fourth insulating layer 40. The second connection electrode CNE2 may be connected to the first connection electrode CNE1 through a contact hole CNT-2 passing through the fourth insulating layer 40. The fifth insulating layer 50 may be disposed on the fourth insulating layer 40 to cover the second connection electrode CNE2. The fifth insulating layer 50 may be an organic layer.

The display element layer D-OL may be disposed on the circuit element layer D-CL. The display element layer D-OL may include a light-emitting element ED, a pixel defining layer PDL, a metal pattern layer JHL, and a low thermal conductive layer PTL.

The light-emitting element ED may include a first electrode AE, a second electrode CE facing the first electrode AE, and a functional layer FL disposed between the first electrode AE and the second electrode CE.

The first electrode AE may be disposed on the circuit element layer D-CL. In an embodiment, the first electrode AE may be disposed on the fifth insulating layer 50 of the circuit element layer D-CL. The first electrode AE may be connected to the second connection electrode CNE2 through a connection contact hole CNT-3 defined in (or passing through) the fifth insulating layer 50. Accordingly, the first electrode AE may be electrically connected to the signal transmission region SCL through the first and second connection electrodes CNE1 and CNE2, thus being electrically connected to a corresponding circuit element. The first electrode AE may include a single-layered structure or a multi-layered structure.

The first electrode AE may be an anode or a cathode. For example, the first electrode AE may be a pixel electrode. The second electrode CE may be a cathode or an anode. The second electrode CE may be a common electrode. For example, in case that the first electrode AE is an anode, the second electrode CE may be a cathode, and in case that the first electrode AE is a cathode, the second electrode CE may be an anode.

The functional layer FL may include at least one light-emitting structure. The functional layer FL may include at least one organic layer commonly provided in the light-emitting regions PXA-R, PXA-G, and PXA-B (see FIG. 5). For example, the functional layer FL may include a common layer commonly provided to the light-emitting regions PXA-R, PXA-G, and PXA-B (see FIG. 5) and a light-emitting layer patterned so as to correspond to each of the light-emitting regions PXA-R, PXA-G, and PXA-B. The common layer may be at least one organic layer, and for example, the common layer may perform a hole transport function or an electron transport function. The configuration of the functional layer FL will be described in more detail later.

For example, the light-emitting element ED according to an embodiment may further include a capping layer disposed on the second electrode CE. The capping layer may include a plurality of layers or a single layer.

The display element layer D-OL may include a pixel defining layer PDL disposed on the circuit element layer D-CL. A light-emitting opening OH may be defined in (or may pass through) the pixel defining layer PDL. The light-emitting opening OH of the pixel defining layer PDL may expose at least a portion of the first electrode AE. In an embodiment, the pixel defining layer PDL may cover an edge portion of the first electrode AE.

The pixel defining layer PDL may have a single-layered structure or multi-layered structure. The pixel defining layer PDL may be formed of a polymer resin. For example, the pixel defining layer PDL may be formed by including a polyacrylate-based resin or a polyimide-based resin. For example, the pixel defining layer PDL may be formed by further including an inorganic material in addition to the polymer resin. For example, the pixel defining layer PDL may be formed by including a light-absorbing material, or may be formed by including a black pigment or black dye. The pixel defining layer PDL formed by including a black pigment or black dye may implement a black pixel defining layer. In case that the pixel defining layer PDL is formed, carbon black or the like may be used as a black pigment or black dye, but embodiments are not limited thereto.

For example, the pixel defining layer PDL may be formed of an inorganic material. For example, the pixel defining layer PDL may be formed of an inorganic material such as silicon nitride (SiNₓ), silicon oxide (SiOₓ), or silicon oxynitride (SiOₓN_{y}).

The encapsulation layer TFE may be disposed on the second electrode CE of the light-emitting element ED. In another example, in case that the light-emitting element ED includes a capping layer, the encapsulation layer TFE may be disposed on the capping layer. The encapsulation layer TFE may cover the light-emitting element ED.

FIG. 7 is a schematic cross-sectional view of a portion of the display panel DP according to an embodiment. The display panel DP may include a base substrate BL, a circuit element layer D-CL, a display element layer D-OL, and an encapsulation layer TFE, which are stacked in the third direction DR3. Regarding the base substrate BL, the circuit element layer D-CL, the display element layer D-OL, and the encapsulation layer TFE, the contents overlapping those described in FIG. 6 will not be described again, and differences will be described for descriptive convenience.

Referring to FIG. 7, the display panel DP may include first to third light-emitting regions PXA-R, PXA-G, and PXA-B, which are distinguished from each other, and a peripheral region NPXA disposed between the first to third light-emitting regions PXA-R, PXA-G, and PXA-B.

The light-emitting regions PXA-R, PXA-G, and PXA-B may be defined by being divided by a pixel defining layer PDL. In an embodiment, the first to third light-emitting regions PXA-R, PXA-G, and PXA-B of the display panel DP may be defined to respectively correspond to partial regions of the first electrodes AE exposed by the light-emitting openings OH.

The display element layer D-OL may include a pixel defining layer PDL and light-emitting elements ED1, ED2, and ED3 divided by the pixel defining layer PDL. The display element layer D-OL may include a first light-emitting element ED1, a second light-emitting element ED2, and a third light-emitting element ED3. The first light-emitting element ED1 may emit red light, the second light-emitting element ED2 may emit green light, and the third light-emitting element ED3 may emit blue light.

The first light-emitting element ED1 may include a first pixel electrode AE1, a first functional layer FL1, and a second electrode CE, the second light-emitting element ED2 may include a second pixel electrode AE2, a second functional layer FL2, and a second electrode CE, and the third light-emitting element ED3 may include a third pixel electrode AE3, a third functional layer FL3, and a second electrode CE. Each of the first to third pixel electrodes AE1, AE2, and AE3 may be referred to as a first electrode.

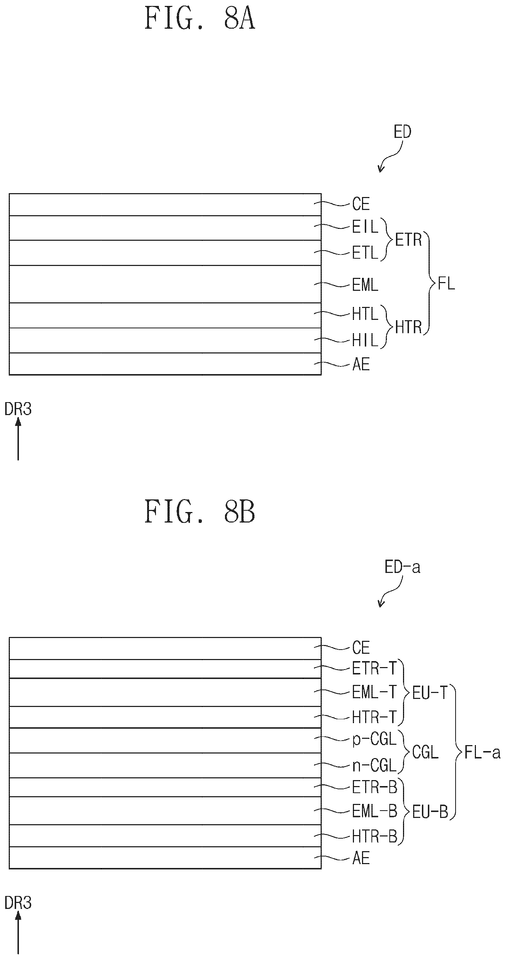

Each of FIG. 8A and 8B is a schematic cross-sectional view illustrating a light-emitting element according to an embodiment. Each of the first to third light-emitting elements ED1, ED2, and ED3 in FIG. 7 may have the composition of the embodiment of the light-emitting element illustrated in FIG. 8A or 8B.

Referring to FIG. 8A, the light-emitting element ED according to an embodiment may include a first electrode AE, a functional layer FL, and a second electrode CE, and the functional layer FL may include a hole transport region HTR, a light-emitting layer EML, and an electron transport region ETR. The light-emitting element ED according to an embodiment may include a single light-emitting structure that is a stacked structure of the hole transport region HTR, the light-emitting layer EML, and the electron transport region ETR. For example, each of the first to third functional layers FL1, FL2, and FL3 of the first to third light-emitting elements ED1, ED2, and ED3 illustrated in FIG. 7 may include a single light-emitting structure that is a stacked structure of the hole transport region HTR, the light-emitting layer EML, and the electron transport region ETR.

In the light-emitting element ED, the first electrode AE may be a transmissive electrode, a semi-transmissive electrode, or a reflective electrode. The first electrode AE may be formed of a metallic material, a metal alloy, or a conductive compound. The first electrode AE may include at least one selected from the group consisting of Ag, Mg, Cu, Al, Pt, Pd, Au, Ni, Nd, Ir, Cr, Li, Ca, LiF, Mo, Ti, W, In, Sn, and Zn, a compound of two or more selected therefrom, a mixture of two or more selected therefrom, or an oxide thereof.

In case that the first electrode AE is a transmissive electrode, the first electrode AE may be composed of a transparent metal oxide such as indium tin oxide (ITO), indium zinc oxide (IZO), zinc oxide (ZnO), or indium tin zinc oxide (ITZO). In case that the first electrode AE is a semi-transmissive electrode or a reflective electrode, the first electrode AE may include Ag, Mg, Cu, Al, Pt, Pd, Au, Ni, Nd, Ir, Cr, Li, Ca, LiF/Ca (a stacked structure of LiF and Ca), LiF/Al (a stacked structure of LiF and Al), Mo, Ti, W, or a compound or mixture thereof (e.g., a mixture of Ag and Mg). In another example, the first electrode AE may have a multi-layered structure including: a reflective film or semi-transmissive film formed of the above materials; and a transparent conductive film formed of indium tin oxide (ITO), indium zinc oxide (IZO), zinc oxide (ZnO), indium tin zinc oxide (ITZO), or the like. For example, the first electrode AE may have a three-layer structure of ITO/Ag/ITO, but embodiments are not limited thereto. For example, embodiments are not limited thereto, and the first electrode AE may include an above-described metallic material, a combination of two or more metallic materials selected from among the above-described metallic materials, an oxide of the above-described metallic materials, or the like.

The second electrode CE may be a transmissive electrode, a semi-transmissive electrode, or a reflective electrode. In case that the second electrode CE is a transmissive electrode, the second electrode CE may be made of a transparent metal oxide such as indium tin oxide (ITO), indium zinc oxide (IZO), zinc oxide (ZnO), or indium tin zinc oxide (ITZO).

In case that the second electrode CE is a transmissive electrode or a reflective electrode, the second electrode CE may contain Ag, Mg, Cu, Al, Pt, Pd, Au, Ni, Nd, Ir, Cr, Li, Ca, LiF/Ca, LiF/Al, Mo, Ti, Yb, W, or a compound or mixture including them (e.g., AgMg, AgYb, or MgYb). In another example, the second electrode CE may have a multi-layered structure including: a reflective film or semi-transmissive film formed of the above materials; and a transparent conductive film formed of an indium tin oxide (ITO), an indium zinc oxide (IZO), a zinc oxide (ZnO), an indium tin zinc oxide (ITZO), or the like. For example, the second electrode CE may contain an above-described metallic material, a combination of two or more metallic materials selected from among the above-described metallic materials, an oxide of the above-described metallic materials, or the like.

The light-emitting layer EML may include a light-emitting material. The light-emitting layer EML may have a single-layered structure made of a single material, a single-layered structure made of different materials, or a multi-layered structure composed of a plurality of layers made of different materials. The light-emitting layer may include a fluorescent or phosphorescent material. In the light-emitting element ED according to an embodiment, the light-emitting layer EML may include an organic light-emitting material, an organic metal complex, a quantum dot, or the like as a light-emitting material.

For example, the light-emitting layer EML included in the first to third functional layers FL1, FL2, and FL3 (see FIG. 7) may emit light of different wavelength ranges. Each of the first to third functional layers FL1, FL2, and FL3 (see FIG. 7) may include a light-emitting layer EML including a different light-emitting material.

FIG. 8A illustrates that the light-emitting element ED includes a single light-emitting layer EML, but the light-emitting element ED may further include an auxiliary light-emitting layer that increases light-emitting efficiency in addition to a main light-emitting layer including a light-emitting material that emits light of a selected color. For example, in an embodiment, the light-emitting layer EML may have a stacked structure of sub-light-emitting layers having different light-emitting material compositions.

The light-emitting element ED may include a hole transport region HTR disposed between the first electrode AE and the light-emitting layer EML. The hole transport region HTR may include at least one of a hole injection layer HIL, a hole transport layer HTL, an auxiliary light-emitting layer, or an electron blocking layer. For example, the hole transport region HTR may include the hole injection layer HIL and the hole transport layer HTL sequentially stacked on the first electrode AE.

For example, the hole transport region HTR included in the first to third functional layers FL1, FL2, and FL3 (see FIG. 7) may be formed simultaneously in a same process step. The hole transport region HTR included in the first to third functional layers FL1, FL2, and FL3 (see FIG. 7) may be formed of a same material. The hole transport region HTR included in the first to third functional layers FL1, FL2, and FL3 (see FIG. 7) may be provided in a same process step by using a same material and then be disconnected by a metal pattern layer JHL so that the hole transport region HTR may be separately disposed in each of the first to third functional layers FL1, FL2, and FL3 (see FIG. 7).

The light-emitting element ED may include an electron transport region ETR disposed between the light-emitting layer EML and the second electrode CE. The electron transport region ETR may include at least one of a hole blocking layer, an electron transport layer ETL, or an electron injection layer EIL. For example, the electron transport region ETR may include the electron transport layer ETL and the electron injection layer EIL disposed on the light-emitting layer EML, but embodiments are not limited thereto. The electron transport region ETR may have a single-layered structure made of a single material, a single-layered structure made of different materials, or a multi-layered structure composed of a plurality of layers made of different materials.

For example, the electron transport region ETR included in the first to third functional layers FL1, FL2, and FL3 (see FIG. 7) may be formed simultaneously in a same process step. The electron transport region ETR included in the first to third functional layers FL1, FL2, and FL3 (see FIG. 7) may be formed of a same material. The electron transport region ETR included in the first to third functional layers FL1, FL2, and FL3 (see FIG. 7) may be provided in a same process step by using a same material and then be disconnected by a metal pattern layer JHL so that the electron transport region ETR may be separately disposed in each of the first to third functional layers FL1, FL2, and FL3 (see FIG. 7).

Referring to FIG. 8B, a light-emitting element ED-a according to an embodiment may include a first electrode AE, a functional layer FL-a, and a second electrode CE, and the functional layer FL-a may include light-emitting structures EU-B and EU-T. The light-emitting structures EU-B and EU-T may respectively include light-emitting layers EMI,-B and EML-T. Accordingly, the functional layer FL-a may include light-emitting layers EMI,-B and EML-T. For example, the light-emitting element ED-a according to an embodiment may be a light-emitting element having a tandem structure including the light-emitting layers EMI,-B and EML-T separated from each other.

The light-emitting element ED-a according to an embodiment may further include a charge generation layer CGL. In case that a voltage is applied to the light-emitting element ED-a, the charge generation layer CGL may generate charges (electrons and holes) by forming a complex through an oxidation-reduction reaction. The charge generation layer CGL may provide the generated charges to each of adjacent light-emitting structures EU-B and EU-T. The charge generation layer CGL may increase the efficiency of the current generated in each of the adjacent light-emitting structures EU-B and EU-T and play a role in controlling the balance of the charges between the adjacent light-emitting structures EU-B and EU-T.

The charge generation layer CGL may have a layer structure in which an n-type charge generation layer n-CGL and a p-type charge generation layer p-CGL are bonded to each other.

The n-type charge generation layer n-CGL may provide electrons to adjacent light-emitting structures EU-B and EU-T. The n-type charge generation layer n-CGL may be a layer in which a base material is doped with an n-dopant. The p-type charge generation layer p-CGL may provide holes to adjacent light-emitting structures EU-B and EU-T. The p-type charge generation layer p-CGL may be a layer in which a base material is doped with a p-dopant.

The light-emitting element ED-a may include a first light-emitting structure EU-B and a second light-emitting structure EU-T disposed on the first light-emitting structure EU-B. The charge generation layer CGL may be disposed between the first light-emitting structure EU-B and the second light-emitting structure EU-T.

The first light-emitting structure EU-B may include a first hole transport region HTR-B, a first light-emitting layer EMI,-B, and a first electron transport region ETR-B, and the second light-emitting structure EU-T may include a second hole transport region HTR-T, a second light-emitting layer EMI,-T, and a second electron transport region ETR-T.

The description of the hole transport region HTR provided with reference to FIG. 8A may be equally applied to the first hole transport region HTR-B and the second hole transport region HTR-T. For example, in the light-emitting element ED-a according to an embodiment, the first hole transport region HTR-B and the second hole transport region HTR-T may have a same structure and be formed of a same material. However, embodiments are not limited thereto, and the first hole transport region HTR-B and the second hole transport region HTR-T may have different stacked structures, or the first hole transport region HTR-B and the second hole transport region HTR-T may be formed by including different hole transport materials.

The description of the light-emitting layer EML provided with reference to FIG. 8A may be equally applied to the first light-emitting layer EML-B and the second light-emitting layer EML-T. For example, in the light-emitting element ED-a according to an embodiment, the first light-emitting layer EMI,-B and the second light-emitting layer EMI,-T may have a same structure and be formed of a same material. However, embodiments are not limited thereto, and the first light-emitting layer EMI,-B and the second light-emitting layer EMI,-T may have different stacked structures, or the first light-emitting layer EMI,-B and the second light-emitting layer EMI,-T may be formed by including different light-emitting materials. For example, each of the first light-emitting layer EMI,-B and the second light-emitting layer EMI,-T may include stacked sub-light-emitting layers or stacked auxiliary light-emitting layers.

The description of the electron transport region ETR with reference to FIG. 8A may be equally applied to the first electron transport region ETR-B and the second electron transport region ETR-T. For example, in the light-emitting element ED-a according to an embodiment, the first electron transport region ETR-B and the second electron transport region ETR-T may have a same structure and be formed of a same material. However, embodiments are not limited thereto, and the first electron transport region ETR-B and the second electron transport region ETR-T may have different stacked structures, or the first electron transport region ETR-B and the second electron transport region ETR-T may be formed by including different electron transport materials.

For example, the light-emitting structures EU-B and EU-T included in the first to third functional layers FL1, FL2, and FL3 (see FIG. 7) may emit light of different wavelength ranges. The first to third functional layers FL1, FL2, and FL3 (see FIG. 7) may include light-emitting layers EMI,-B and EMI,-T each including a different light-emitting material.

The first hole transport region HTR-B included in the first to third functional layers FL1, FL2, and FL3 (see FIG. 7) may be formed simultaneously in a same process step. The first hole transport region HTR-B included in the first to third functional layers FL1, FL2, and FL3 (see FIG. 7) may be provided in a same process step by using a same material and then be disconnected by a metal pattern layer JHL so that the first hole transport region HTR-B may be separately disposed in each of the first to third functional layers FL1, FL2, and FL3 (see FIG. 7). For example, the second hole transport region HTR-T included in the first to third functional layers FL1, FL2, and FL3 (see FIG. 7) may be provided in a same process step by using a same material and then be disconnected by a metal pattern layer JHL so that the second hole transport region HTR-T may be separately disposed in each of the first to third functional layers FL1, FL2, and FL3 (see FIG. 7).

For example, the first electron transport region ETR-B included in the first to third functional layers FL1, FL2, and FL3 (see FIG. 7) may be formed simultaneously in a same process step. The first electron transport region ETR-B may be provided in a same process step by using a same material and then be disconnected by a metal pattern layer JHL so that the first electron transport region ETR-B may be separately disposed in each of the first to third functional layers FL1, FL2, and FL3 (see FIG. 7). For example, the second electron transport region ETR-T included in the first to third functional layers FL1, FL2, and FL3 (see FIG. 7) may be formed simultaneously in a same process step. The second electron transport region ETR-T may be provided in a same process step by using a same material and then be disconnected by a metal pattern layer JHL so that the second electron transport region ETR-T may be separately disposed in each of the first to third functional layers FL1, FL2, and FL3 (see FIG. 7).

The charge generation layer CGL included in the first to third functional layers FL1, FL2, and FL3 (see FIG. 7) may be formed simultaneously in a same process step. The charge generation layer CGL included in the first to third functional layers FL1, FL2, and FL3 (see FIG. 7) may be formed in a same process step by using a same material and then be disconnected so that the charge generation layer CGL may be separately disposed in each of the first to third functional layers FL1, FL2, and FL3 (see FIG. 7).

Referring again to FIG. 7, the functional layers FL1, FL2, and FL3 of the light-emitting elements ED1, ED2, and ED3 may extend to the light-emitting regions PXA-R, PXA-G, and PXA-B and the peripheral region NPXA adjacent to the light-emitting regions PXA-R, PXA-G, and PXA-B.

The display panel DP according to an embodiment may include a metal pattern layer JHL. The metal pattern layer JHL may overlap the pixel defining layer PDL. The metal pattern layer JHL may not overlap the upper surface (e.g., the entire upper surface) of the pixel defining layer PDL, and may overlap only a portion of the upper surface of the pixel defining layer PDL.

The metal pattern layer JHL may be a Joule heating wire that generates heat in case that a current is supplied. In case that a current flows through the metal pattern layer JHL, heat in a range of about 400°C or higher may be generated. The metal pattern layer JHL may be formed of a metallic material having high resistance characteristics. For example, the metal pattern layer JHL may include molybdenum (Mo), titanium (Ti), or tungsten (W). For example, the metal pattern layer JHL may be formed of a metallic material including molybdenum (Mo). However, embodiments are not limited thereto, and any metallic material may be used for the metal pattern layer JHL without limitation as long as it is a metallic material that generates heat in a range of about 90°C or higher, which is able to remove an organic material in case that an electric current is provided.

FIG. 7 illustrates that in the display panel DP according to an embodiment, the metal pattern layers JHL may be disposed to respectively correspond to the peripheral regions NPXA and may be spaced apart from each other on a cross section. However, embodiments are not limited thereto, and in order to readily provide a current to the metal pattern layers JHL, at least portions of the metal pattern layers JHL disposed to respectively correspond to the peripheral regions NPXA may be connected to each other. For example, the metal pattern layers JHL may overlap the peripheral regions NPXA and be provided as an integral part in which they are connected to each other.

The metal pattern layer JHL may be disposed in such a way that organic layers provided as common layers in adjacent light-emitting regions PXA-R, PXA-B, and PXA-G are disconnected from each other in some regions. In an embodiment, the common layers may be hole transport regions HTR, HTR-T, and HTR-B (see FIGS. 8A and 8B), electron transport regions ETR, ETR-T, and ETR-B (see FIGS. 8A and 8B), or a charge generation layer CGL (see FIG. 8B).

In case that the common layers are connected to each other between the light-emitting regions PXA-R, PXA-B, and PXA-G, leakage current may occur through the common layers. Thus, a color mixing phenomenon may occur between the light-emitting regions PXA-R, PXA-B, and PXA-G. Therefore, through the disconnection of the common layers, display quality may be improved. For example, for the disconnection of the common layers, there is a method of using the step difference of a structure by separately providing the structure on the pixel defining layer PDL, but in an embodiment, by using a metal pattern layer JHL that generates heat by a Joule heating method without introducing (or forming) a separate structure, it is possible to readily form a structure in which the common layers are disconnected from each other.

For example, since the organic layers are patterned by using the metal pattern layer JHL without introducing (or forming) a separate structure, the disconnected organic layers may be disposed although the size of the light emitting region (e.g., pixel region) is small, and therefore, the display panel DP according to an embodiment may have high resolution characteristics. The display panel DP according to an embodiment may be used in miniaturized electronic devices, etc. and may have ultra-high resolution characteristics.

The display panel DP according to an embodiment may include a low thermal conductive layer PTL disposed below the metal pattern layer JHL. The low thermal conductive layer PTL may be disposed (e.g., directly disposed) below the metal pattern layer JHL. The low thermal conductive layer PTL may overlap the metal pattern layer JHL (e.g., the entire metal pattern layer JHL). The low thermal conductive layer PTL may be disposed (e.g., directly disposed) between the pixel defining layer PDL and the metal pattern layer JHL.

The low thermal conductive layer PTL may prevent heat generated in the metal pattern layer JHL from being transferred to the light-emitting regions PXA-R, PXA-G, and PXA-B. The low thermal conductive layer PTL may suppress the heat generated in the metal pattern layer JHL from being transferred to the functional layer FL disposed in the light-emitting regions PXA-R, PXA-G, and PXA-B and may prevent the functional layer FL from being damaged, thereby being able to improve the light-emitting efficiency and quality of the light-emitting elements ED1, ED2, and ED3.

The low thermal conductive layer PTL may have a thermal conductivity in a range of about 1.0 W/mK or less. For example, the thermal conductivity of the low thermal conductive layer PTL may be about 0.5 W/mK or less. For example, the thermal conductivity of the low thermal conductive layer PTL may be about 0.28 W/mK.

The low thermal conductive layer PTL may be formed by including a polymer-type amorphous carbon film. The proportion of sp³ carbon bonds in the polymer-type amorphous carbon film may range from about 50% to about 70%. For example, the proportion of sp3 carbon bonds in the polymer-type amorphous carbon film forming the low thermal conductive layer PTL may be about 60%. For example, the low thermal conductive layer PTL may have a refractive index in a range of about 1.75 or less at about 550 nm wavelength and a density in a range of about 1.2 g/cm³ to about 1.6 g/cm³. For example, the low thermal conductive layer PTL may be formed of a polymer-type amorphous carbon film having about 60% sp3 carbon bonds, a refractive index of about 1.64 at about 550 nm wavelength, and a density of about 1.3 g/cm³.

In an embodiment, the low thermal conductive layer PTL may be formed of a polymer-type amorphous carbon film having about 50% to about 70% sp3 carbon bonds, a refractive index in a range of about 1.75 or less at about 550 nm wavelength, and a density of about 1.2 g/cm³ to about 1.6 g/cm³, thereby having low thermal conductivity characteristics.

In an embodiment, the low thermal conductive layer PTL may be formed using a deposition facility. The low thermal conductive layer PTL may be formed by providing hydrocarbon gas and using a chemical vapor deposition (CVD) facility. For example, the low thermal conductive layer PTL may be formed by providing C₂H₄ gas as a source.

In the display panel DP according to an embodiment, the functional layers FL1, FL2, and FL3 of the light-emitting elements ED1, ED2, and ED3 may not overlap the metal pattern layer JHL. The functional layers FL1, FL2, and FL3 may be disposed in the light-emitting openings OH respectively corresponding to the light-emitting regions PXA-R, PXA-G, and PXA-B and may be partially disposed to extend above the pixel defining layers PDL adjacent to the light-emitting openings OH.

The first to third functional layers FL1, FL2, and FL3 disposed in the light-emitting regions PXA-R, PXA-G, and PXA-B may be disconnected by the metal pattern layers JHL and may be separated from each other. The first to third functional layers FL1, FL2, and FL3 may be respectively disposed in the light-emitting regions PXA-R, PXA-G, and PXA-B and overlap at least a portion of the peripheral region NPXA adjacent to the light-emitting regions PXA-R, PXA-G, and PXA-B, but may not overlap the metal pattern layer JHL.

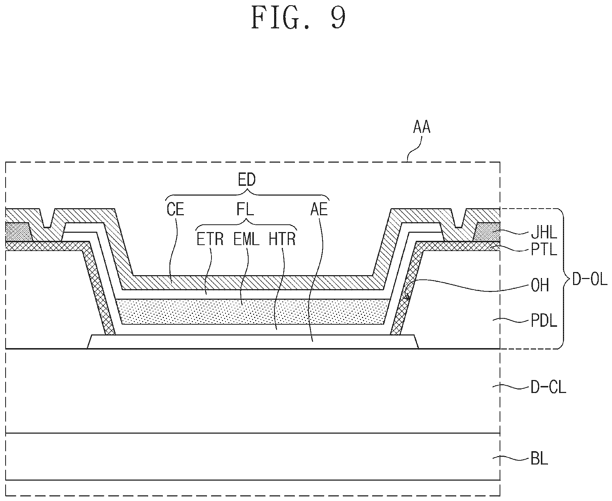

FIG. 9 is an enlarged schematic view of a region "AA" of FIG. 7. The region "AA" is selected from the second light-emitting region PXA-G and the peripheral region NPXA adjacent to the second light-emitting region PXA-G, but the structure illustrated in FIG. 9 may be equally applied to other light-emitting regions and their adjacent region.

FIG. 9 illustrates a case in which the functional layer FL includes a hole transport region HTR, a light-emitting layer EML, and an electron transport region ETR. The light-emitting layer EML of the functional layer FL may be provided by being patterned in the light-emitting opening OH. For example, the light-emitting layer EML may be patterned and provided in the light-emitting opening OH defined to correspond to each of the light-emitting regions PXA-R, PXA-G, and PXA-B illustrated in FIG. 7.

Referring again to FIG. 9, the hole transport region HTR and the electron transport region ETR of the functional layer FL may be disposed in the light-emitting opening OH and may be partially disposed above the pixel defining layer PDL by extending from a portion thereof disposed in the light-emitting opening OH. The hole transport region HTR and the electron transport region ETR extending above the pixel defining layer PDL may be positioned on the low thermal conductive layer PTL.

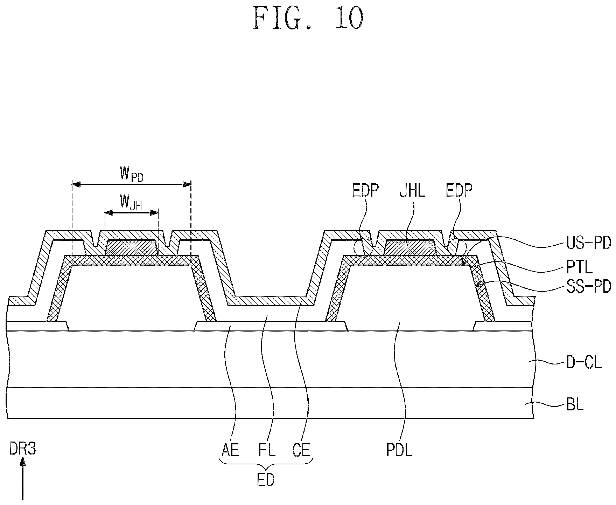

FIG. 10 is an enlarged schematic cross-sectional view of a portion of the display panel DP according to an embodiment. FIG. 10 illustrates a partial region including a light-emitting element ED and a pixel defining layer PDL adjacent to the light-emitting element ED.

In an embodiment, the low thermal conductive layer PTL may cover the pixel defining layer PDL. The low thermal conductive layer PTL may cover an upper surface US-PD and a side surface SS-PD of the pixel defining layer PDL.

In an embodiment, on a cross section perpendicular to the base substrate BL, a first width W_{JH} of the metal pattern layer JHL in a direction (e.g., horizontal direction) may be smaller than a second width W_{PD} of the pixel defining layer PDL in the direction. For example, the first width W_{JH} of the metal pattern layer JHL may be about 1/2 or less of the second width W_{PD} of the pixel defining layer PDL. For example, the second width W_{PD} of the pixel defining layer PDL may be in a range of about 4 *µ*m to about 5 *µ*m, and the first width W_{JH} of the metal pattern layer JHL may be in a range of about 1 *µ*m to about 2 *µ*m. For example, in an embodiment, the second width W_{PD} of the pixel defining layer PDL may be about 2 *µ*m, and the first width W_{JH} of the metal pattern layer JHL may be about 1 *µ*m or less. For example, the second width W_{PD} of the pixel defining layer PDL which is compared therewith may be the width of the upper portion of the pixel defining layer PDL disposed adjacent to the metal pattern layer JHL.

In an embodiment, since the metal pattern layer JHL has a smaller width than the pixel defining layer PDL, it is possible to reduce the amount of heat that is transferred to the organic layers disposed in the light-emitting regions PXA-R, PXA-B, and PXA-G separated by the pixel defining layer PDL although heat is generated from the metal pattern layer JHL. For example, in the display panel DP according to an embodiment, as the low thermal conductive layer PTL is disposed to be in contact with (e.g., in direct contact with) the metal pattern layer JHL so as to overlap the metal pattern layer JHL (e.g., the entire metal pattern layer JHL), it is possible to minimize damage to the organic layers in the light-emitting regions while the common layers disconnected by the metal pattern layer JHL are included, thereby having excellent display quality. For example, the organic layers may be a hole transport region, an electron transport region, a charge generation layer, or the like.

Referring to FIG. 10, an edge portion EDP of the functional layer FL extending to be disposed above the pixel defining layer PDL may be disposed (e.g., directly disposed) on the low thermal conductive layer PTL. For example, the edge portion EDP of the functional layer FL may be spaced apart from the metal pattern layer JHL. For example, the shape and arrangement position of the edge portion EDP of the functional layer FL are not limited to those illustrated in FIG. 10 or the like. The shape and arrangement position of the edge portion EDP of the functional layer FL may be adjusted by changing Joule heating conditions in the metal pattern layer JHL.

The upper surface of the low thermal conductive layer PTL that is exposed without being covered by the functional layer FL may be covered by the second electrode CE. The second electrode CE may cover the functional layer FL and the metal pattern layer JHL.

In an embodiment, each of the metal pattern layer JHL and the low thermal conductive layer PTL may be formed to have a thickness in the range of several thousand angstroms (Å). For example, each of the metal pattern layer JHL and the low thermal conductive layer PTL may have a thickness of about 2000 Å. However, embodiments are not limited thereto.

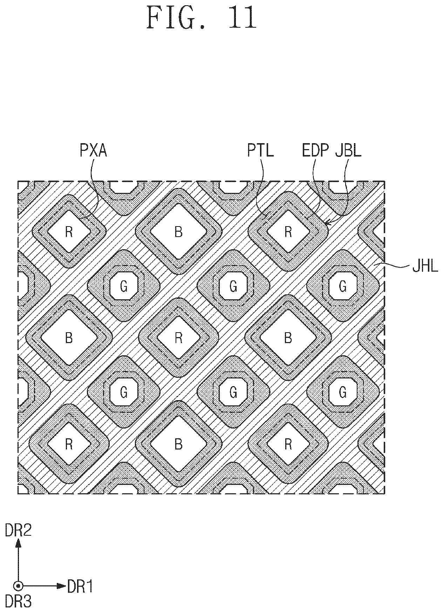

FIG. 11 is a schematic plan view briefly illustrating a portion of the display panel DP according to an embodiment. FIG. 11 illustrates a portion of the display region.

FIG. 11 illustrates the arrangement relationship of the light-emitting region PXA, the metal pattern layer JHL, the low thermal conductive layer PTL, and the edge portion EDP of the functional layer FL on a plane (or in plan view). In FIG. 11, the peripheral portion of the light-emitting region PXA may correspond to the peripheral region NPXA (see FIG. 5). The metal pattern layer JHL and the low thermal conductive layer PTL may be disposed in the peripheral region NPXA (see FIG. 5).

In an embodiment, the low thermal conductive layer PTL may overlap the region (e.g., the entire region) in which the metal pattern layer JHL is disposed and may be provided to a region further expanding toward the light-emitting region PXA. When viewed on a plane defined by the first and second directions DR1 and DR2 (or in plan view), the area (or size) of the low thermal conductive layer PTL may be greater than the area (or size) of the metal pattern layer JHL.

When viewed on a plane (or in plan view), a metal layer boundary line JBL defined by the edge portion EDP of the functional layer FL and an edge portion of the metal pattern layer JHL may be positioned in the peripheral region, and the edge portion EDP may be closer to the light-emitting region PXA than the metal layer boundary line JBL.

For example, in FIG. 11, the outer portion of the light-emitting region PXA may be a portion in which the pixel defining layer PDL (see FIG. 7) is disposed, and the area (or size) of the metal pattern layer JHL in plan view may be smaller than the area (or size) of the pixel defining layer PDL. For example, the metal pattern layer JHL may be spaced apart from the light-emitting region PXA and, with an area (or size) smaller than the pixel defining layer PDL (see FIG. 7), the metal pattern layer JHL may overlap the pixel defining layer PDL (see FIG. 7), thereby preventing the organic layers in the light-emitting region PXA from being damaged. For example, since the edge portion EDP of the functional layer FL is disposed so as not to overlap the metal pattern layer JHL, and the functional layer FL is separated from the peripheral region NPXA (see FIG. 5), quality degradation due to leakage current may be prevented and the display panel DP may have excellent display quality.

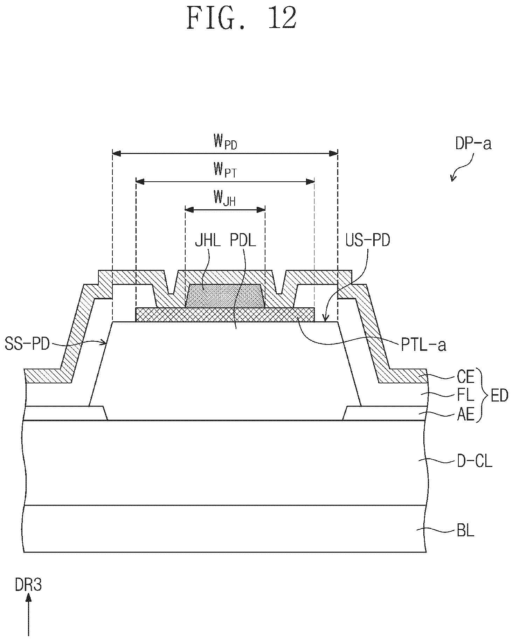

Each of FIGS. 12 to 15 is a schematic cross-sectional view illustrating a portion of a display panel DP according to an embodiment. In the descriptions of the display panels DP according to embodiments, which are described with reference to FIGS. 12 to 15, the descriptions similar to (or substantially same as) those provided with reference to FIGS. 1A to 11 will not be provided again and differences will be explained for descriptive convenience.

A display panel DP-a according to an embodiment illustrated in FIG. 12 may include a low thermal conductive layer PTL-a disposed (e.g., directly disposed) between the upper surface US-PD of the pixel defining layer PDL and the metal pattern layer JHL.

In an embodiment, on a cross section perpendicular to the base substrate BL, a first width W_{JH} of the metal pattern layer JHL in a direction (e.g., horizontal direction) may be smaller than a second width W_{PD} of the upper surface US-PD of the pixel defining layer PDL adjacent to the metal pattern layer JHL in the direction and a third width W_{PT} of the upper surface of the low thermal conductive layer PTL-a adjacent to the metal pattern layer JHL in the direction.

In the display panel DP-a according to an embodiment, the side surface SS-PD of the pixel defining layer PDL may be covered by the functional layer FL. For example, a portion of the upper surface US-PD of the pixel defining layer PDL which is not covered by the low thermal conductive layer PTL-a may also be covered by the functional layer FL.

In an embodiment, the third width W_{PT} of the low thermal conductive layer PTL-a may be smaller than the second width W_{PD} of the upper surface US-PD of the pixel defining layer PDL. For example, the low thermal conductive layer PTL-a may overlap the metal pattern layer JHL (e.g., the entire metal pattern layer JHL) having a sufficiently greater width than the metal pattern layer JHL, and therefore, it is possible to prevent heat generated from the metal pattern layer JHL from being transferred to the functional layer FL.

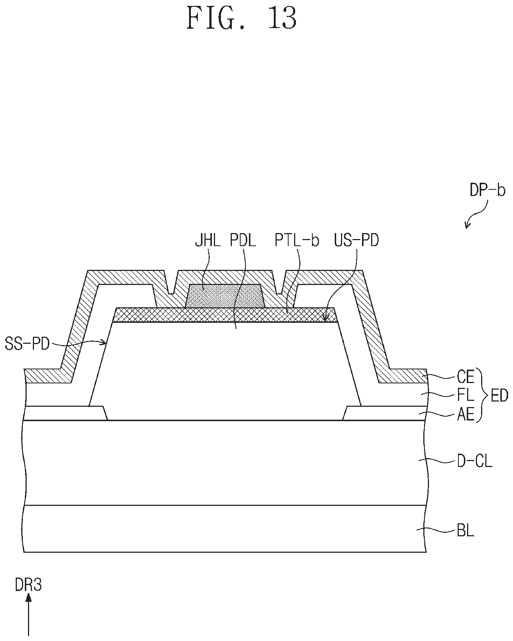

A display panel DP-b according to an embodiment illustrated in FIG. 13 may include a low thermal conductive layer PTL-b disposed (e.g., directly disposed) between the upper surface US-PD of the pixel defining layer PDL and the metal pattern layer JHL. The low thermal conductive layer PTL-b may overlap the upper surface US-PD (e.g., the entire upper surface US-PD) of the pixel defining layer PDL. For example, in the display panel DP-b according to an embodiment, the side surface SS-PD of the pixel defining layer PDL may be covered by the functional layer FL.

In an embodiment, the low thermal conductive layer PTL-b may cover the upper surface US-PD (e.g., the entire upper surface US-PD) of the pixel defining layer PDL, thereby preventing heat generated from the metal pattern layer JHL from being transferred to the functional layer FL.

In embodiments illustrated in FIGS. 12 and 13, the low thermal conductive layers PTL-a and PTL-b may be deposited on the pixel defining layer PDL and then be patterned together with the pixel defining layer PDL in a same process step. In an embodiment, which is illustrated in FIGS. 12 and 13, the second electrode CE may be disposed (e.g., directly disposed) on portions of the low thermal conductive layers PTL-a and PTL-b which are not covered by the functional layer FL.

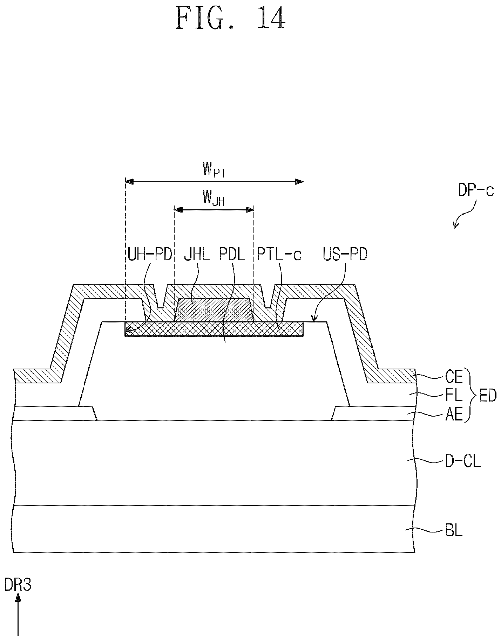

In a display panel DP-c according to an embodiment, which is illustrated in FIG. 14, a concave portion UH-PD may be defined (or formed) on the upper surface US-PD of the pixel defining layer PDL. In an embodiment, a low thermal conductive layer PTL-c may be disposed in the concave portion UH-PD.

In an embodiment, a first width W_{JH} of the metal pattern layer JHL may be smaller than a third width W_{PT} of the low thermal conductive layer PTL-c. The edge portion of the functional layer FL may be spaced apart from the metal pattern layer JHL and be disposed on the low thermal conductive layer PTL-c. For example, unlike what is illustrated in the drawing, the edge portion of the functional layer FL may be spaced apart from the metal pattern layer JHL, non-overlap the low thermal conductive layer PTL-c, and be disposed on the pixel defining layer PDL. The upper surface of the low thermal conductive layer PTL-c that is exposed without being covered by the functional layer FL may be covered by the second electrode CE. The second electrode CE may cover the functional layer FL and the metal pattern layer JHL.

In the display panel DP-c according to an embodiment, since the low thermal conductive layer PTL-c has a sufficiently greater width than the metal pattern layer JHL and overlap the metal pattern layer JHL (e.g., the entire metal pattern layer JHL), it is possible to prevent heat generated from the metal pattern layer JHL from being transferred to the functional layer FL, thereby having excellent display quality.

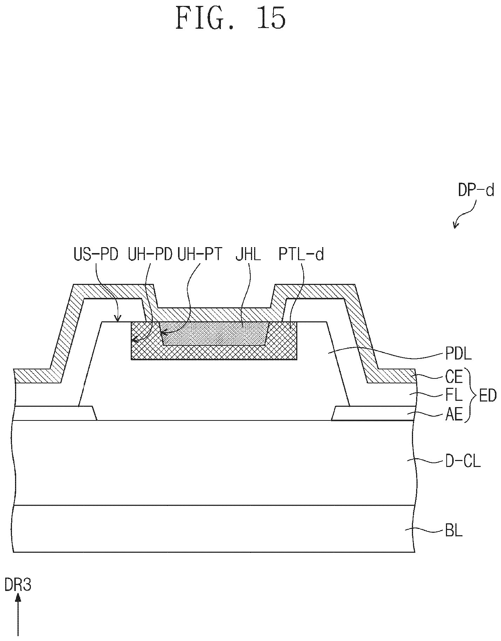

In a display panel DP-d according to an embodiment, which is illustrated in FIG. 15, a first concave portion UH-PD may be defined (or formed) on the upper surface US-PD of the pixel defining layer PDL. In an embodiment, a low thermal conductive layer PTL-d may be disposed in the first concave portion UH-PD. For example, a second concave portion UH-PT may be defined (or formed) on the upper surface of the low thermal conductive layer PTL-d, and the metal pattern layer JHL may be disposed in the second concave portion UH-PT.

The low thermal conductive layer PTL-d may cover the lower surface and the side surfaces of the metal pattern layer JHL so that the metal pattern layer JHL may not contact the pixel defining layer PDL.

The edge portion of the functional layer FL may be spaced apart from the metal pattern layer JHL and be disposed on the low thermal conductive layer PTL-d. For example, unlike what is illustrated in the drawing, the edge portion of the functional layer FL may be spaced apart from the metal pattern layer JHL, non-overlap the low thermal conductive layer PTL-d, and be disposed on the pixel defining layer PDL. The upper surface of the low thermal conductive layer PTL-d that is exposed without being covered by the functional layer FL may be covered by the second electrode CE. The second electrode CE may cover the functional layer FL and the metal pattern layer JHL.

In the display panel DP-d according to an embodiment, since the low thermal conductive layer PTL-d has a sufficiently greater width than the metal pattern layer JHL and overlap the metal pattern layer JHL (e.g., the entire metal pattern layer JHL), it is possible to prevent heat generated from the metal pattern layer JHL from being transferred to the functional layer FL, thereby having excellent display quality.

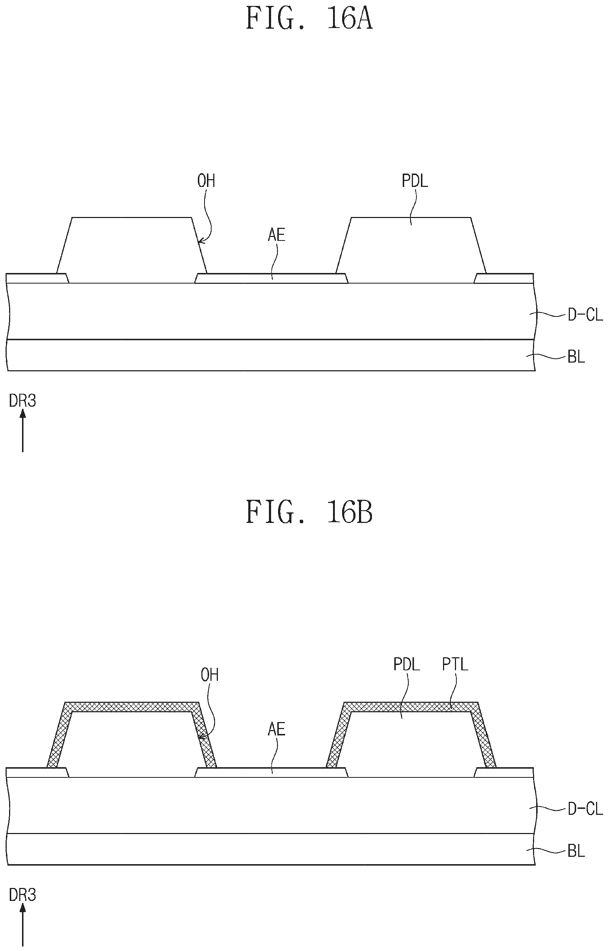

Hereinafter, a method of manufacturing a display device according to an embodiment will be described with reference to FIGS. 16A to 16H. FIGS. 16A to 16H illustrate steps of the method of manufacturing the display panel DP according to an embodiment. In describing

FIGS. 16A to 16H, the same/similar reference numerals will be used for the same/similar components as those described with reference to FIGS. 1A to 15, and redundant descriptions will be omitted for descriptive convenience.

The method of manufacturing the display panel DP according to an embodiment may include: forming a first electrode AE on a circuit element layer D-CL; forming a pixel defining layer PDL on the circuit element layer D-CL; forming a low thermal conductive layer PTL on the pixel defining layer PDL; forming a metal pattern layer JHL, which overlaps the pixel defining layer PDL, on the low thermal conductive layer PTL; providing a preliminary functional layer P-FL so as to overlap the pixel defining layer PDL and the first electrode AE; forming a functional layer FL by providing a current to the metal pattern layer JHL to remove a portion of the preliminary functional layer P-FL overlapping the metal pattern layer JHL; forming a second electrode CE so as to cover the functional layer FL and the metal pattern layer JHL; and forming an encapsulation layer TFE on the second electrode CE.

FIG. 16A illustrates forming a first electrode AE on a circuit element layer D-CL and forming a pixel defining layer PDL on the circuit element layer D-CL.

The circuit element layer D-CL may be formed on the base substrate BL, and the first electrode AE may be formed on the circuit element layer D-CL. The first electrode AE may be patterned and provided on the base substrate BL.

After the forming of the first electrode AE, a pixel defining layer PDL may be formed on the circuit element layer D-CL. Light-emitting openings OH may be defined/formed in (or pass through) the pixel defining layer PDL. The upper surface of the patterned first electrode AE may be exposed through each of the light-emitting openings OH.

FIG. 16B illustrates forming a low thermal conductive layer PTL on a pixel defining layer PDL. FIG. 16B illustrates an embodiment, which is illustrated in FIG. 7 in which the low thermal conductive layer PTL covers the pixel defining layer PDL. However, embodiments are not limited thereto, and in the case of the embodiments of FIGS. 12 to 15 in which the low thermal conductive layer is disposed in a different shape, the low heat-conducting layer may be formed so as to at least partially overlap the pixel defining layer PDL.

The low thermal conductive layer PTL may be formed of a polymer-type amorphous carbon film. The forming of the low thermal conductive layer PTL may include forming a polymer-type amorphous carbon film with hydrocarbon gas by using a deposition facility. For example, the low thermal conductive layer PTL may be formed by using a chemical vapor deposition (CVD) facility and providing C₂H₄ gas.

The low thermal conductive layer PTL may not be provided on the upper surface of the first electrode AE disposed in the light-emitting opening OH and may be formed on the pixel defining layer PDL.

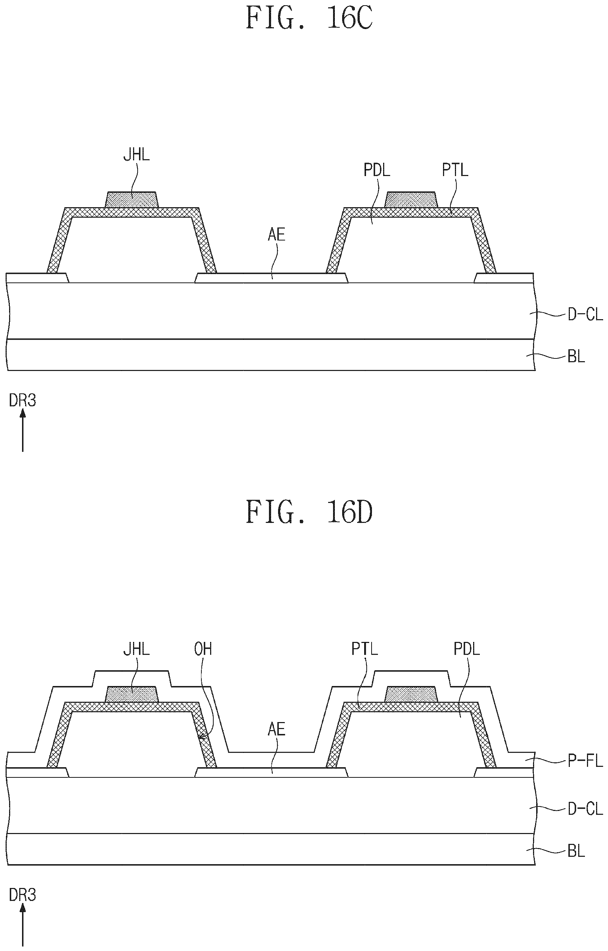

FIG. 16C illustrates forming a metal pattern layer JHL. The metal pattern layer JHL may overlap the pixel defining layer PDL and be formed on the low thermal conductive layer PTL.

The metal pattern layer JHL may be a Joule heating wire. In case that a current is provided to the metal pattern layer JHL, heat may be generated in the metal pattern layer JHL.

The metal pattern layer JHL may be disposed (e.g., directly disposed) on the low thermal conductive layer PTL. The metal pattern layer JHL may be formed to have a smaller width than the low thermal conductive layer PTL. By forming the metal pattern layer JHL so that the lower surface thereof is sufficiently covered by the low thermal conductive layer PTL, the transfer of heat generated from the metal pattern layer JHL may be blocked by the low thermal conductive layer PTL having low heat conductivity.

FIG. 16D illustrates providing a preliminary functional layer P-FL. The preliminary functional layer P-FL may be provided/formed to overlap the first electrode AE and the pixel defining layer PDL. The preliminary functional layer P-FL may be provided so as to overlap (e.g., completely overlap) the light-emitting regions PXA-R, PXA-G, and PXA-B (see FIG. 7) and the peripheral region NPXA (see FIG. 7). For example, the preliminary functional layer P-FL may include at least one of a hole transport region HTR (see FIG. 9) or an electron transport region ETR (see FIG. 9). For example, the light-emitting layer EML (see FIG. 9) of the light-emitting element ED (see FIG. 9) may not be provided as a common layer like the preliminary functional layer P-FL, but may be patterned and provided so as to be disposed in each of the light-emitting openings OH. For example, in case that the light-emitting element has the structure of FIG. 8B, the charge generation layer CGL (see FIG. 8B) may also be provided as a preliminary functional layer P-FL.

The preliminary functional layer P-FL, which forms the hole transport region HTR (see FIG. 9), the light-emitting layer EML patterned and provided to be disposed in each of the light-emitting openings OH, and the preliminary functional layer P-FL, which forms the electron transport region ETR (see FIG. 9), may be provided sequentially. For example, in case that the light-emitting element has the structure of FIG. 8B, the preliminary functional layer P-FL, which forms the hole transport region HTR-B or HTR-T, the light-emitting layer EMI,-B or EML-T patterned and provided to be disposed in each of the light-emitting openings OH, and the preliminary functional layer P-FL, which forms the electron transport region ETR-B or ETR-T, may be provided sequentially in each of the first light-emitting structure EU-B and the second light-emitting structure EU-T. For example, the charge generation layer CGL (see FIG. 8B) may also be provided as the preliminary functional layer P-FL after the first light-emitting structure EU-B is provided.

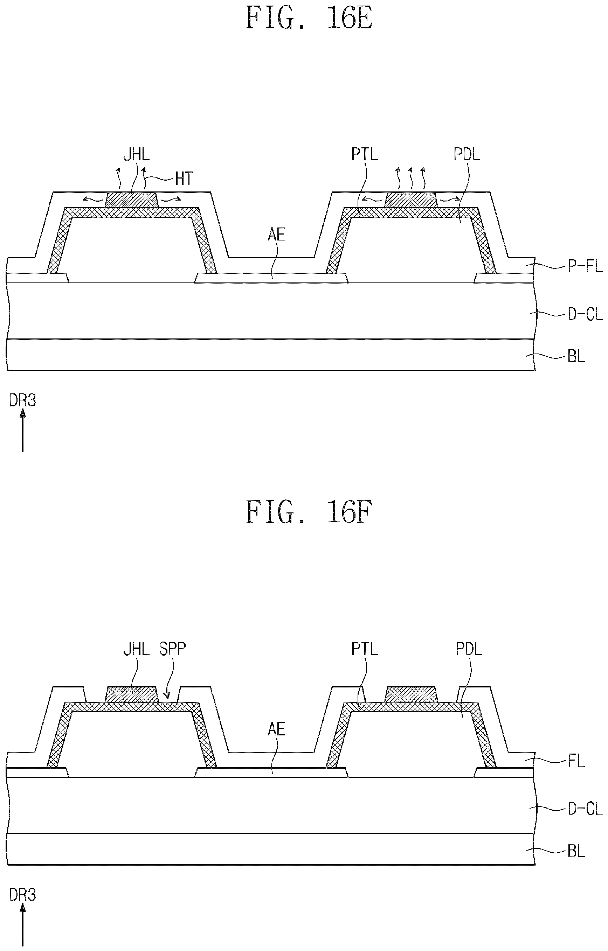

FIGS. 16E and 16F illustrate forming a functional layer. After the preliminary functional layer P-FL is provided/formed, the forming of the functional layer FL may be performed by providing a current to the metal pattern layer JHL to remove a portion of the preliminary functional layer P-FL overlapping the metal pattern layer JHL.

In case that a current is provided to the metal pattern layer JHL, heat HT may be generated in the metal pattern layer JHL. The heat HT generated in the metal pattern layer JHL may be transferred to an adjacent preliminary functional layer P-FL, and the portion of the preliminary functional layer P-FL may be removed by the heat HT. The portion of the preliminary functional layer P-FL may be sublimated and removed by the heat generated from the metal pattern layer JHL.

A portion of the preliminary functional layer P-FL overlapping the metal pattern layer JHL and a portion of the preliminary functional layer P-FL adjacent to the metal pattern layer JHL may be removed. A partial region of the preliminary functional layer P-FL may be removed by the metal pattern layer JHL, and the functional layer FL may be formed.

The functional layer FL may be formed so as not to overlap the metal pattern layer JHL. For example, in an embodiment, the functional layer FL may be formed to be spaced apart from the metal pattern layer JHL at a selected distance.

The shape and size of a separated portion SPP between the metal pattern layer JHL and the functional layer FL may vary according to the process conditions for removing the preliminary functional layer P-FL, such as the amount of a current provided to the metal pattern layer JHL, the time for providing the current to the metal pattern layer JHL, and the resistance properties of a metallic material used for the metal pattern layer JHL.

Since the method of manufacturing the display panel DP according to an embodiment includes forming the functional layer FL by using the metal pattern layer JHL, which generates heat by a Joule heating method, to remove a portion of the preliminary functional layer P-FL adjacent to the metal pattern layer JHL, it is possible to readily perform patterning so that the functional layers FL may not be connected to each other in adjacent light-emitting regions PXA-R, PXA-G, and PXA-B (see FIG. 7). Since the method of manufacturing the display panel DP according to an embodiment includes providing a metal pattern layer JHL and a low thermal conductive layer PTL, the preliminary functional layer P-FL may be readily disconnected and damage to the functional layer FL may be minimized or prevented. Therefore, this method may be used to manufacture a display panel DP capable of preventing degradation of display quality and color mixing which may occur due to leakage current in adjacent light-emitting regions PXA-R, PXA-G, and PXA-B (see FIG. 7).

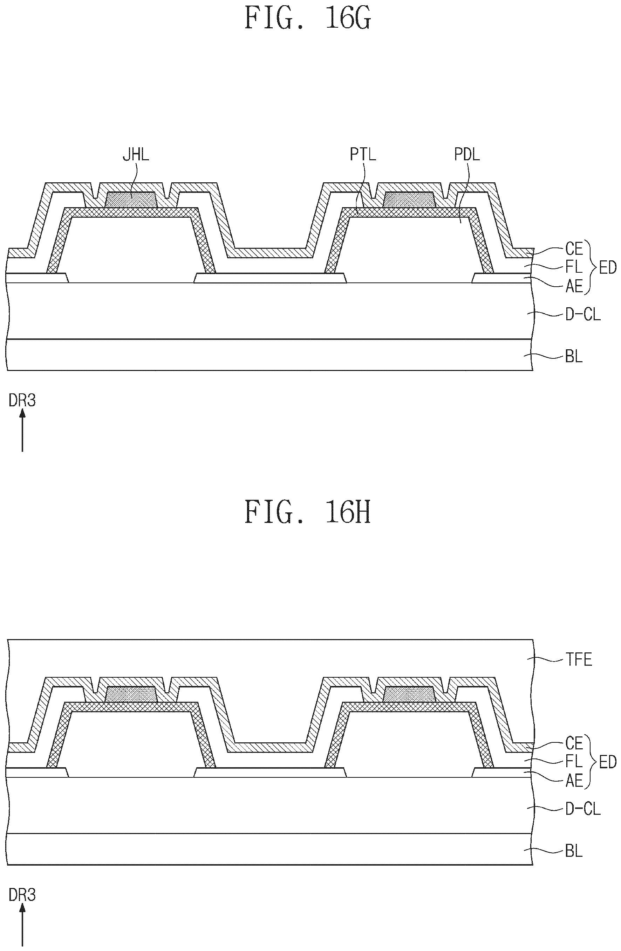

FIG. 16G illustrates forming a second electrode CE. The second electrode CE may be formed to cover the functional layer FL and the metal pattern layer JHL. The second electrode CE may also be disposed in the separated portion SPP between the metal pattern layer JHL and the functional layer FL. The second electrode CE may be provided as a common layer in the light-emitting regions PXA-R, PXA-G, and PXA-B (see FIG. 7) and the peripheral region NPXA.

FIG. 16H illustrates forming an encapsulation layer TFE. The encapsulation layer TFE may cover the light-emitting element ED. In FIG. 16H, the encapsulation layer TFE is illustrated as one layer, but the encapsulation layer TFE may be formed to include a plurality of layers including at least one inorganic layer and at least one organic layer.

The display panel DP according to an embodiment may include a metal pattern layer JHL disposed on a pixel defining layer PDL, a low thermal conductive layer PTL disposed (e.g., directly disposed) between the pixel defining layer PDL and the metal pattern layer JHL, and a light-emitting element ED including a functional layer FL disposed to non-overlap the metal pattern layer JHL. Therefore, the light-emitting regions PXA-R, PXA-B, and PXA-G may have excellent light-emitting characteristics due to the functional layer FL having good quality, and no leakage current occurs between adjacent light-emitting regions PXA-R, PXA-B, and PXA-G due to the disconnected functional layers, thereby having excellent display quality.

For example, the method of manufacturing the display panel DP according to an embodiment may include forming a low thermal conductive layer PTL disposed on a pixel defining layer PDL, forming a metal pattern layer JHL on the low thermal conductive layer PTL, and forming a functional layer FL by removing a preliminary functional layer P-FL disposed on the metal pattern layer JHL with the use of heat generated in the metal pattern layer JHL. Therefore, the functional layer FL may be readily formed to be disconnected between adjacent light-emitting regions, and the film quality of the functional layer disposed in the light-emitting regions PXA-R, PXA-B, and PXA-G may be maintained excellent. Accordingly, this method may be used to manufacture a display panel DP having excellent display quality.

As discussed, embodiments may provide a display panel comprising: a base substrate; a circuit element layer disposed on the base substrate; a pixel defining layer disposed on the circuit element layer and including a light-emitting opening; a light-emitting element disposed on the circuit element layer, the light-emitting element including: a first electrode, a second electrode facing the first electrode, and a functional layer disposed between the first electrode and the second electrode; a metal pattern layer disposed on the pixel defining layer; and a low thermal conductive layer disposed between the pixel defining layer and the metal pattern layer.

The first electrode may be located in the light-emitting opening. A portion of the pixel defining layer may overlap a portion (e.g. an end portion) of the first electrode.

The functional layer may be located in the light-emitting opening. A portion of the functional layer may overlap a portion of the pixel defining layer.

The functional layer may be a light emitting layer,

Each first electrode may be provided for one opening, e.g. defining a sub-pixel.

The light-emitting opening of the pixel defining layer may expose at least a portion of the first electrode.

The second electrode may be located over the pixel defining layer and the light-emitting opening.

The second electrode may be provided as a common electrode for multiple light-emitting openings, that each define a sub-pixel.

The low thermal conductive layer may be provided over the sides of the pixel defining layer, and not in the light-emitting opening between two pixel defining layer portions.

The metal pattern layer may be provided on a portion of the pixel defining layer.

The pixel defining layer may have a single-layered structure or multi-layered structure. The pixel defining layer may be formed of a polymer resin. For example, the pixel defining layer may be formed from a polyacrylate-based resin or a polyimide-based resin. For example, the pixel defining layer may be formed by further including an inorganic material in addition to the polymer resin.

The metal pattern layer may be a Joule heating wire that generates heat when a current is supplied.

The metal pattern layer may be formed of a metallic material having high resistance characteristics. For example, the metal pattern layer JHL may include molybdenum (Mo), titanium (Ti), or tungsten (W). For example, the metal pattern layer JHL may be formed of a metallic material including molybdenum (Mo).

The low thermal conductive layer may be disposed (e.g., directly disposed) between the pixel defining layer and the metal pattern layer.

The low thermal conductive layer may suppress the heat generated in the metal pattern layer from being transferred to the functional layer.

As discussed, embodiments may provide a method of manufacturing a display panel, the method comprising: forming a first electrode on a circuit element layer; forming a pixel defining layer on the circuit element layer; forming a low thermal conductive layer on the pixel defining layer; forming a metal pattern layer on the low thermal conductive layer so as to overlap the pixel defining layer; providing a preliminary functional layer so as to overlap the pixel defining layer and the first electrode; forming a functional layer by providing a current to the metal pattern layer to remove a portion of the preliminary functional layer overlapping the metal pattern layer; forming a second electrode so as to cover the functional layer and the metal pattern layer; and forming an encapsulation layer on the second electrode.

The display panel DP according to an embodiment may include a disconnected organic layer in a non-light-emitting region, thereby preventing current leakage between adjacent light-emitting regions and having excellent display quality.

The method of manufacturing the display panel DP according to an embodiment may include forming a low thermal conductive layer PTL between a metal pattern layer JHL and a pixel defining layer PDL and disconnecting an organic film by using the metal pattern layer JHL, and therefore, this method may be used to manufacture a display panel DP having excellent display quality.

In concluding the detailed description, those skilled in the art will appreciate that many variations and modifications may be made to the embodiments without substantially departing from the principles and scope of the disclosure. Therefore, the disclosed embodiments are used in a generic and descriptive sense only and not for purposes of limitation.

## Claims

1. A display panel comprising:
a base substrate;
a circuit element layer disposed on the base substrate;
a pixel defining layer disposed on the circuit element layer and including a light-emitting opening;
a light-emitting element disposed on the circuit element layer, the light-emitting element including:
a first electrode,
a second electrode facing the first electrode, and
a functional layer disposed between the first electrode and the second electrode;
a metal pattern layer disposed on the pixel defining layer; and
a low thermal conductive layer disposed between the pixel defining layer and the metal pattern layer.

2. The display panel of claim 1, wherein the low thermal conductive layer has a thermal conductivity in a range of about 1.0 W/mK or less.

3. The display panel of claim 1 or 2, wherein the functional layer does not overlap the metal pattern layer;
optionally wherein the functional layer comprises: a light-emitting layer; and an organic layer disposed on at least one of an upper portion or a lower portion of the light-emitting layer, the organic layer overlaps the light-emitting opening and a portion of the pixel defining layer adjacent to the light-emitting opening and is spaced apart from the metal pattern layer.

4. The display panel of any one of claims 1 to 3, wherein the low thermal conductive layer comprises a polymer-type amorphous carbon film.

5. The display panel of claim 4, wherein a proportion of sp³ carbon bonds in the polymer-type amorphous carbon film is in a range of about 50% to about 70%.

6. The display panel of claim 4 or 5, wherein the low thermal conductive layer has a refractive index in a range of about 1.75 or less at about 550 nm wavelength and a density in a range of about 1.2 g/cm³ to about 1.6 g/cm³.

7. The display panel of any one of claims 1 to 6, wherein, on a cross section perpendicular to the base substrate, a first width of the metal pattern layer in a direction is smaller than a second width of the pixel defining layer in the direction;
optionally wherein the first width is about 1/2 or less of the second width.

8. The display panel of any one of claims 1 to 7, wherein a width of the metal pattern layer in a direction is smaller than a width of the low thermal conductive layer in the direction.

9. The display panel of any one of claims 1 to 8, wherein the low thermal conductive layer covers an upper surface and a side surface of the pixel defining layer.

10. The display panel of any one of claims 1 to 9, wherein:
the low thermal conductive layer is disposed on an upper surface of the pixel defining layer; and
a side surface of the pixel defining layer is covered by the functional layer.

11. The display panel of any one of claims 1 to 10, wherein:
a concave portion is formed on an upper surface of the pixel defining layer; and the low thermal conductive layer is disposed in the concave portion; or
wherein: a first concave portion is formed on an upper surface of the pixel defining layer; the low thermal conductive layer is disposed in the first concave portion; a second concave portion is formed on an upper surface of the low thermal conductive layer; and the metal pattern layer is disposed in the second concave portion.

12. A method of manufacturing a display panel, the method comprising:
forming a first electrode on a circuit element layer;
forming a pixel defining layer on the circuit element layer;
forming a low thermal conductive layer on the pixel defining layer;
forming a metal pattern layer on the low thermal conductive layer so as to overlap the pixel defining layer;
providing a preliminary functional layer so as to overlap the pixel defining layer and the first electrode;
forming a functional layer by providing a current to the metal pattern layer to remove a portion of the preliminary functional layer overlapping the metal pattern layer;
forming a second electrode so as to cover the functional layer and the metal pattern layer; and
forming an encapsulation layer on the second electrode.

13. The method of claim 12, wherein:
the metal pattern layer is a Joule heating wire; and
the forming of a functional layer by removing the portion of the preliminary functional layer comprises removing the portion of the preliminary functional layer by sublimating the portion of the preliminary functional layer with heat generated in the metal pattern layer.

14. The method of claim 12 or 13, wherein the forming of the low thermal conductive layer comprises forming a polymer-type amorphous carbon film with hydrocarbon gas using a deposition facility.

15. The method of any one of claims 12 to 14, wherein the metal pattern layer has a width smaller than that of the low thermal conductive layer in a direction; and/or
wherein the functional layer is formed so as not to overlap the metal pattern layer.
